# EUROPEAN PATENT SPECIFICATION

(11) **EP 3 340 283 B1**
(45) Date of publication and mention of the grant of the patent: **20.05.2020**
(21) Application number: 16837063.3
(22) Date of filing: 10.08.2016
(51) Int. Cl.: H01L 21/306, H01L 21/3105

(54) **WAFER WASHING METHOD, AND LIQUID CHEMICAL USED IN SAME**
WAFERREINIGUNGSVERFAHREN UND DARIN VERWENDETE CHEMISCHE FLÜSSIGKEIT
PROCÉDÉ DE LAVAGE DE TRANCHE, ET PRODUIT CHIMIQUE LIQUIDE UTILISÉ DANS CELUI-CI

(30) Priority: 20.08.2015 JP 2015162769; 15.03.2016 JP 2016050563; 29.07.2016 JP 2016150067
(43) Date of publication of application: 27.06.2018
(73) Proprietor: Central Glass Company, Limited, Yamaguchi 755-0001 (JP)
(72) Inventor: SAIO, Takashi, Matsusaka-shi Mie 515-0001 (JP); OKUMURA, Yuzo, Matsusaka-shi Mie 515-0001 (JP); FUKUI, Yuki, Matsusaka-shi Mie 515-0001 (JP); FUKAZAWA, Hiroki, Matsusaka-shi Mie 515-0001 (JP); TAKATA, Tomohiro, Matsusaka-shi Mie 515-0001 (JP); KUMON, Soichi, Matsusaka-shi Mie 515-0001 (JP); ABE, Kazuyuki, Ube-shi Yamaguchi 755-0001 (JP); WATANABE, Shota, Ube-shi Yamaguchi 755-0001 (JP); IMACHI, Masayoshi, Ube-shi Yamaguchi 755-0001 (JP)
(74) Representative: Manitz Finsterwald Patent- und Rechtsanwaltspartnerschaft mbB
(86) International application number: PCT/JP2016/073619
(87) International publication number: WO 2017/030073

(56) References cited:
- JP-A- H07 245 283
- JP-A- H11 345 796
- JP-A- 2010 272 852
- JP-A- 2012 033 873
- JP-A- 2013 118 347
- US-A1- 2013 056 023

## Description

### Field of the Invention

The present invention relates to a method for cleaning a wafer with a specific liquid chemical by means of a cleaning machine whose liquid contact part contains a vinyl chloride resin.

### Background Art

There is a wafer cleaning machine of the type in which any part brought into contact with a cleaning liquid or processing liquid (referred to as "liquid contact part") contains a vinyl chloride resin as disclosed in Patent Documents 1 to 8. In this type of wafer cleaning machine, it is required that the vinyl chloride resin is not deteriorated by the cleaning liquid or processing liquid. Examples of the wafer cleaning machine with such a vinyl chloride resin-containing liquid contact part are those in which a part of a cleaning processing chamber brought into contact with a cleaning liquid or processing liquid is partially or wholly made of a vinyl chloride resin and those in which a part brought into contact with a cleaning liquid or processing liquid, such as tank, pipe, connection member, nozzle or the like, is partially or wholly made of a vinyl chloride resin.

On the other hand, it is required that semiconductor devices for network applications and digital home appliances attain higher performance, higher functionality and lower power consumption. The fine processing of circuit patterns has accordingly been pursued. With the fine processing of circuit patterns, however, pattern collapses are becoming a problem. The manufacturing of the semiconductor device makes heavy use of a cleaning process to remove particles and metal impurities. Eventually, the cleaning process occupies 30 to 40% of the entire semiconductor manufacturing process. The pattern collapse is a phenomenon occurring in the cleaning process when the aspect ratio of hole or recess portions of the uneven circuit pattern becomes high. More specifically, the pattern collapse refers to a collapse of the pattern caused due to the passage of a gas-liquid interface through the pattern after washing or rinsing. The design of the pattern has to be changed in order to prevent a pattern collapse. Further, the occurrence of a pattern collapse leads to a deterioration in manufacturing yield. It is thus demanded to develop a technique for preventing a pattern collapse in the cleaning process.

The formation of a water-repellent protective film on a surface of the pattern is known as an effective technique for preventing a pattern collapse. Such water repelling treatment needs to be performed without drying the surface of the pattern. The water-repellent protective film is hence formed using a water-repellent protective film-forming liquid chemical to impart water repellency to the surface of the pattern.

The present applicant has disclosed in Patent Document 9 a protective film-forming liquid chemical used, in a process of producing a wafer having on a surface thereof a fine uneven pattern which at least partially contains a silicon element, for forming a water-repellent protective film on the uneven pattern of the wafer so as to improve a cleaning process in which a pattern collapse is likely to be induced without causing a deterioration in throughput. More specifically, disclosed is a protective film-forming liquid chemical used, in a process of cleaning a wafer having on a surface thereof a fine uneven pattern which at least partially contains a silicon element, for forming a water-repellent protective film on at least surfaces of recess portions of the uneven pattern, and characterized by containing: a silicon compound (A) represented by the following general formula [1]: and an acid capable of donating a proton to the silicon compound (A) and/or an acid capable of accepting an electron from the silicon compound (A), wherein the total amount of water in starting raw materials of the liquid chemical is 5000 mass ppm or less relative to the total amount of the raw materials. Also disclosed is a wafer cleaning method using such a protective film-forming liquid chemical.

R¹*ₐ*Si(H)*_{b}*(X)_{4-*a*-*b*} [A]

In the general formula [A], R¹ is each independently at least one group selected from monovalent C1-C18 hydrocarbon-containing organic groups and monovalent C1-C8 fluoroalkyl chain-containing organic groups; X is each independently at least one group selected from halogen groups, monovalent organic groups of which element bonded to Si is oxygen or nitrogen, and nitrile group; *a* is an integer of 1 to 3; *b* is an integer of 0 to 2; and the sum of *a* and *b* is 3 or smaller.

### Prior Art Documents

### Patent Documents

Patent Document 1: Japanese Laid-Open Patent Publication No. H05-259136
Patent Document 2: Japanese Laid-Open Patent Publication No. H07-245283
Patent Document 3: Japanese Laid-Open Patent Publication No. H10-189527
Patent Document 4: Japanese Laid-Open Patent Publication No. H10-229062
Patent Document 5: Japanese Laid-Open Patent Publication No. H11-283949
Patent Document 6: Japanese Laid-Open Patent Publication No. 2001-087725
Patent Document 7: Japanese Laid-Open Patent Publication No. 2008-098440
Patent Document 8: Japanese Laid-Open Patent Publication No. 2010-003739
Patent Document 9: Japanese Laid-Open Patent Publication No. 2012-033873

### Summary of the Invention

### Problems to be Solved by the Invention

It is herein assumed that a wafer having on a surface thereof a fine uneven pattern which at least partially contains a silicon element is cleaned by means of a wafer cleaning machine whose liquid contact part contains a vinyl chloride resin. In the case where a water-repellent protective film-forming liquid chemical disclosed in e.g. Example 4 of Patent Document 9 is used in this cleaning process, the vinyl chloride resin may be deteriorated by the liquid chemical.

In view of the above circumstances, it is an object of the present invention to provide a water-repellent protective film-forming liquid chemical (hereinafter occasionally simply referred to as "liquid chemical") used, in a process of cleaning a wafer having on a surface thereof a fine uneven pattern which at least partially contains a silicon element (hereinafter occasionally simply referred to as "wafer") by means of a wafer cleaning machine whose liquid contact part contains a vinyl chloride resin, for forming a water-repellent protective film (hereinafter occasionally simply referred to as "protective film") on the uneven pattern of the wafer without deteriorating the vinyl chloride resin. It is also an object of the present invention to provide a wafer cleaning method using such a liquid chemical.

### Means for Solving the Problems

The present invention provides a method for cleaning a wafer by means of a wafer cleaning machine, the wafer having on a surface thereof a fine uneven pattern at least partially containing a silicon element, the wafer cleaning machine having a liquid contact part containing a vinyl chloride resin,
the method comprising retaining a water-repellent protective film-forming liquid chemical at least in a recess portion of the uneven pattern, thereby forming a water-repellent protective film on a surface of the recess portion,
the water-repellent protective film-forming liquid chemical comprising:
an alkoxysilane represented by the following general formula [1];
at least one kind selected from the group consisting of a sulfonic acid represented by the following general formula [2], an anhydride of the sulfonic acid, a salt of the sulfonic acid and a sulfonic acid derivative represented by the following general formula [3]; and
a diluent solvent,

   (R¹)*ₐ*Si(H)*_{b}*(OR²)_{4-*a*-*b*} [1]

   where R¹ is each independently at least one group selected from the group consisting of monovalent C₁-C₁₈ hydrocarbon groups in which a part or all of hydrogen atoms may be substituted with a fluorine atom; R² is each independently a monovalent C₁-C₁₈ hydrocarbon group in which a part or all of hydrogen atoms may be substituted with a fluorine atom; *a* is an integer of 1 to 3; *b* is an integer of 0 to 2; and the sum *of a* and *b* is 3 or smaller,

   R³-S(=O)₂OH [2]

   where R³ is a group selected from the group consisting of monovalent C₁-C₈ hydrocarbon groups in which a part or all of hydrogen atoms may be substituted with a fluorine atom, and hydroxyl group,

   R³-S(=O)₂O-Si(H)_{3-*c*}(R⁴)*_{c}* [3]

   where R³ is a monovalent C₁-C₈ hydrocarbon group in which a part or all of hydrogen atoms may be substituted with a fluorine atom; R⁴ is each independently at least one group selected from the group consisting of monovalent C₁-C₁₈ hydrocarbon groups in which a part or all of hydrogen atoms may be substituted with a fluorine atom; and c is an integer of 1 to 3,
wherein the diluent solvent contains, based on 100 mass% of the entire diluent solvent, 80 to 100 mass% of at least one kind selected from the group consisting of hexane, heptane, octane, nonane, decane, dodecane, tetradecane, hexadecane, octadecane, eicosane, cyclohexane, methylcyclohexane, decalin, benzene, toluene, xylene, diethylbenzene, dipropyl ether, ethyl butyl ether, dibutyl ether, ethyl amyl ether, diamyl ether, methyl cyclopentyl ether, ethyl hexyl ether, dihexyl ether, dioctyl ether, diphenyl ether, methyl perfluoropropyl ether, ethyl perfluorobutyl ether, methyl perfluorohexyl ether, ethyl perfluorohexyl ether, 1-hexanethiol, 2-hexanethiol, 3-hexanethiol, 2-methyl-1-pentanethiol, 3-methyl-1-pentanethiol, 4-methyl-1-pentanethiol, 2-methyl-2-pentanethiol, 3-methyl-2-pentanethiol, 4-methyl-2-pentanethiol, 2-methyl-3-pentanethiol, 3-methyl-3-pentanethiol, 2,2-dimethyl-1-butanethiol, 3,3-dimethyl-1-butanethiol, 3,3-dimethyl-2-butanethiol, 2-ethyl-1-butanethiol, 1-heptanethiol, 2-heptanethiol, 3-heptanethiol, 4-heptanethiol, benzylthiol, 1-octanethiol, 2-octanethiol, 3-octanethiol, 4-octanethiol, 2-ethyl-1-hexanethiol, 1-nonanethiol, 2-nonanethiol, 3-nonanethiol, 4-nonanethiol, 5-nonanethiol, 1-decanethiol, 2-decanethiol, 3-decanethiol, decanethiol, 5-decanethiol, tert-decanethiol, 1-undecanethiol, 2-undecanethiol, 3-undecanethiol, 4-undecanethiol, 5-undecanethiol, 6-undecanethiol, 1-dodecanethiol, 2-dodecanethiol, 3-dodecanethiol, 4-dodecanethiol, 5-dodecanethiol, 6-dodecanethiol, tert-dodecanethiol, 1-tridecanethiol, 2-tridecanethiol, 3-tridecanethiol, 4-tridecanethiol, 5-tridecanethiol, 6-tridecanethiol and 7-tridecanethiol, wherein hexane, heptane, octane, nonane, decane, dodecane, tetradecane, hexadecane, octadecane and eicosane may be in the linear form or in the branched form and the ethers may be in the linear form or in the branched form.

The sulfonic acid is preferably at least one selected from the group consisting of sulfonic acids represented by the following general formula [4]

R⁵-S(=O)₂OH [4]

where R⁵ is a group selected from the group consisting of monovalent C₁-C₈ hydrocarbon groups in which a part or all of hydrogen atoms may be substituted with a fluorine atom.

The anhydride of the sulfonic acid is preferably at least one selected from the group consisting of anhydrides of sulfonic acids represented by the following general formula [4]

R⁵-S(=O)₂OH [4]

where R⁵ is a group selected from the group consisting of monovalent C₁-C₈ hydrocarbon groups in which a part or all of hydrogen atoms may be substituted with a fluorine atom.

The salt of the sulfonic acid is preferably at least one selected from the group consisting of ammonium salts and alkylamine salts of sulfonic acids represented by the following general formula [4]

R⁵-S(=O)₂OH [4]

where R⁵ is a group selected from the group consisting of monovalent C₁-C₈ hydrocarbon groups in which a part or all of hydrogen atoms may be substituted with a fluorine atom.

The sulfonic acid derivative is preferably at least one selected from the group consisting of sulfonic acid derivatives represented by the following general formula [5]

R⁶-S(=O)₂O-Si(CH₃)₂(R⁷) [5]

where R⁶ is a monovalent C₁-C₈ hydrocarbon group in which a part or all of hydrogen atoms may be substituted with a fluorine atom; and R⁷ is a monovalent C₁-C₁₈ hydrocarbon group in which a part or all of hydrogen atoms may be substituted with a fluorine atom.

The hydrocarbon is preferably a hydrocarbon of 6 to 13 carbon atoms.

The alkoxysilane is preferably at least one selected from the group consisting of alkoxysilanes represented by the following general formula [7]

(R¹⁰)*_{d}*Si(OR¹¹)_{4-*d*} [7]

where R¹⁰ is each independently a monovalent C₁-C₁₈ hydrocarbon group in which a part or all of hydrogen atoms may be substituted with a fluorine atom; R¹¹ is each independently a monovalent C₁-C₁₂ hydrocarbon group; and *d* is 2 or 3.

The alkoxysilane is preferably at least one selected from the group consisting of monoalkoxysilanes represented by the following general formula [8]

(R¹⁰)-Si(CH₃)₂(OR¹¹) [8]

where R¹⁰ is a monovalent C₁-C₁₈ hydrocarbon group in which a part or all of hydrogen atoms may be substituted with a fluorine atom; and R¹¹ is a monovalent C₁-C₁₂ hydrocarbon group.

The concentration of the alkoxysilane in the water-repellent protective film-forming liquid chemical is preferably 0.5 to 35 mass%.

The total concentration of the sulfonic acid, the anhydride of the sulfonic acid, the salt of the sulfonic acid and the sulfonic acid derivative in the water-repellent protective film-forming liquid chemical is preferably 0.0001 to 5 mass%.

It is preferable to, after retaining the water-repellent protective film-forming liquid chemical at least in the recess portion of the uneven pattern and thereby forming the water-repellent protective film on the surface of the recess portion, remove the water-repellent protective film-forming liquid chemical from the recess portion by drying.

It is further preferable to, after retaining the water-repellent protective film-forming liquid chemical at least in the recess portion of the uneven pattern and thereby forming the water-repellent protective film on the surface of the recess portion, replace the water-repellent protective film-forming liquid chemical in the recess portion with a cleaning liquid, which is different from the water-repellent protective film-forming liquid chemical, and then remove the cleaning liquid from the recess portion by drying.

After the drying, the water-repellent protective film may be removed by performing at least one treatment selected from the group consisting of heating treatment, light irradiation treatment, ozone exposure treatment, plasma irradiation treatment and corona discharge treatment on the surface of the wafer.

The above cleaning method may comprise preparing the water-repellent protective film-forming liquid chemical by mixing a water-repellent protective film-forming liquid chemical kit,
the water-repellent protective film-forming liquid chemical kit comprising at least first and second liquids,
the first liquid including the alkoxysilane represented by the above general formula [1], or the alkoxysilane represented by the above general formula [1] and the diluent solvent,
the second liquid including the at least one kind selected from the group consisting of the sulfonic acid represented by the above general formula [2], the anhydride of the sulfonic acid, the salt of the sulfonic acid and the sulfonic acid derivative represented by the above general formula [3], or the at least one kind selected from the group consisting of the sulfonic acid represented by the above general formula [2], the anhydride of the sulfonic acid, the salt of the sulfonic acid and the sulfonic acid derivative represented by the above general formula [3] and the diluent solvent,
at least one of the first and second liquids containing the diluent solvent.

Further, the present invention provides a water-repellent protective film-forming liquid chemical for use in a process of cleaning a wafer by means of a wafer cleaning machine, the wafer having on a surface thereof a fine uneven pattern at least partially containing a silicon element, the wafer cleaning machine having a liquid contact part containing a vinyl chloride resin, the water-repellent protective film-forming liquid chemical comprising:
an alkoxysilane represented by the following general formula [1];
at least one kind selected from the group consisting of a sulfonic acid represented by the following general formula [2], an anhydride of the sulfonic acid, a salt of the sulfonic acid and a sulfonic acid derivative represented by the following general formula [3]; and
a diluent solvent,

   (R¹)*ₐ*Si(H)*_{b}*(OR²)_{4-*a*-*b*} [1]

   where R¹ is each independently at least one group selected from the group consisting of monovalent C₁-C₁₈ hydrocarbon groups in which a part or all of hydrogen atoms may be substituted with a fluorine atom; R² is each independently a monovalent C₁-C₁₈ hydrocarbon group in which a part or all of hydrogen atoms may be substituted with a fluorine atom; *a* is an integer of 1 to 3; *b* is an integer of 0 to 2; and the sum of *a* and *b* is 3 or smaller,

   R³-S(=O)₂OH [2]

   where R³ is a group selected from the group consisting of monovalent C₁-C₈ hydrocarbon groups in which a part or all of hydrogen atoms may be substituted with a fluorine atom, and hydroxyl group,

   R³-S(=O)₂O-Si(H)_{3-*c*}(R⁴)*_{c}* [3]

   where R³ is a monovalent C₁-C₈ hydrocarbon group in which a part or all of hydrogen atoms may be substituted with a fluorine atom; R⁴ is each independently at least one group selected from the group consisting of monovalent C₁-C₁₈ hydrocarbon groups in which a part or all of hydrogen atoms may be substituted with a fluorine atom; and c is an integer of 1 to 3,
wherein the diluent solvent contains, based on 100 mass% of the entire diluent solvent, 80 to 100 mass% of at least one kind selected from the group consisting of hexane, heptane, octane, nonane, decane, dodecane, tetradecane, hexadecane, octadecane, eicosane, cyclohexane, methylcyclohexane, decalin, benzene, toluene, xylene, diethylbenzene, dipropyl ether, ethyl butyl ether, dibutyl ether, ethyl amyl ether, diamyl ether, methyl cyclopentyl ether, ethyl hexyl ether, dihexyl ether, dioctyl ether, diphenyl ether, methyl perfluoropropyl ether, ethyl perfluorobutyl ether, methyl perfluorohexyl ether, ethyl perfluorohexyl ether, 1-hexanethiol, 2-hexanethiol, 3-hexanethiol, 2-methyl-1-pentanethiol, 3-methyl-1-pentanethiol, 4-methyl-1-pentanethiol, 2-methyl-2-pentanethiol, 3-methyl-2-pentanethiol, 4-methyl-2-pentanethiol, 2-methyl-3-pentanethiol, 3-methyl-3-pentanethiol, 2,2-dimethyl-1-butanethiol, 3,3-dimethyl-1-butanethiol, 3,3-dimethyl-2-butanethiol, 2-ethyl-1-butanethiol, 1-heptanethiol, 2-heptanethiol, 3-heptanethiol, 4-heptanethiol, benzylthiol, 1-octanethiol, 2-octanethiol, 3-octanethiol, 4-octanethiol, 2-ethyl-1-hexanethiol, 1-nonanethiol, 2-nonanethiol, 3-nonanethiol, 4-nonanethiol, 5-nonanethiol, 1-decanethiol, 2-decanethiol, 3-decanethiol, 4-decanethiol, 5-decanethiol, tert-decanethiol, 1-undecanethiol, 2-undecanethiol, 3-undecanethiol, 4-undecanethiol, 5-undecanethiol, 6-undecanethiol, 1-dodecanethiol, 2-dodecanethiol, 3-dodecanethiol, 4-dodecanethiol, 5-dodecanethiol, 6-dodecanethiol, tert-dodecanethiol, 1-tridecanethiol, 2-tridecanethiol, 3-tridecanethiol, 4-tridecanethiol, 5-tridecanethiol, 6-tridecanethiol and 7-tridecanethiol, wherein hexane, heptane, octane, nonane, decane, dodecane, tetradecane, hexadecane, octadecane and eicosane may be in the linear form or in the branched form and the ethers may be in the linear form or in the branched form.

The sulfonic acid is preferably at least one selected from the group consisting of sulfonic acids represented by the following general formula [4]

R⁵-S(=O)₂OH [4]

where R⁵ is a group selected from the group consisting of monovalent C₁-C₈ hydrocarbon groups in which a part or all of hydrogen atoms may be substituted with a fluorine atom.

The anhydride of the sulfonic acid is preferably at least one selected from the group consisting of anhydrides of sulfonic acids represented by the following general formula [4]

R⁵-S(=O)₂OH [4]

where R⁵ is a group selected from the group consisting of monovalent C₁-C₈ hydrocarbon groups in which a part or all of hydrogen atoms may be substituted with a fluorine atom.

The salt of the sulfonic acid is preferably at least one selected from the group consisting of ammonium salts and alkylamine salts of sulfonic acids represented by the following general formula [4]

R⁵-S(=O)₂OH [4]

where R⁵ is a group selected from the group consisting of monovalent C₁-C₈ hydrocarbon groups in which a part or all of hydrogen atoms may be substituted with a fluorine atom.

The sulfonic acid derivative is preferably at least one selected from the group consisting of sulfonic acid derivatives represented by the following general formula [5]

R⁶-S(=O)₂O-Si(CH₃)₂(R⁷) [5]

where R⁶ is a monovalent C₁-C₈ hydrocarbon group in which a part or all of hydrogen atoms may be substituted with a fluorine atom; and R⁷ is a monovalent C₁-C₁₈ hydrocarbon group in which a part or all of hydrogen atoms may be substituted with a fluorine atom.

The hydrocarbon is preferably a hydrocarbon of 6 to 13 carbon atoms.

The alkoxysilane is preferably at least one selected from the group consisting of alkoxysilanes represented by the following general formula [7]

(R¹⁰)*_{d}*Si(OR¹¹)_{4-*d*} [7]

where R¹⁰ is each independently a monovalent C₁-C₁₈ hydrocarbon group in which a part or all of hydrogen atoms may be substituted with a fluorine atom; R¹¹ is each independently a monovalent C₁-C₁₂ hydrocarbon group; and *d* is 2 or 3.

The alkoxysilane is preferably at least one selected from the group consisting of monoalkoxysilanes represented by the following general formula [8]

(R¹⁰)-Si(CH₃)₂(OR¹¹) [8]

where R¹⁰ is a monovalent C₁-C₁₈ hydrocarbon group in which a part or all of hydrogen atoms may be substituted with a fluorine atom; and R¹¹ is a monovalent C₁-C₁₂ hydrocarbon group.

The concentration of the alkoxysilane in the water-repellent protective film-forming liquid chemical is preferably 0.5 to 35 mass%.

The total concentration of the sulfonic acid, the anhydride of the sulfonic acid, the salt of the sulfonic acid and the sulfonic acid derivative in the water-repellent protective film-forming liquid chemical is preferably 0.0001 to 5 mass%.

Furthermore, the present invention provides a water-repellent protective film-forming liquid chemical kit to be mixed for preparing the above water-repellent protective film-forming liquid chemical, comprising at least first and second liquids,
the first liquid containing the alkoxysilane represented by the above general formula [1], or the alkoxysilane represented by the above general formula [1] and the diluent solvent,
the second liquid containing the at least one kind selected from the group consisting of the sulfonic acid represented by the above general formula [2], the anhydride of the sulfonic acid, the salt of the sulfonic acid and the sulfonic acid derivative represented by the above general formula [3], or the at least one kind selected from the group consisting of the sulfonic acid represented by the above general formula [2], the anhydride of the sulfonic acid, the salt of the sulfonic acid and the sulfonic acid derivative represented by the above general formula [3] and the diluent solvent,
at least one of the first and second liquids containing the diluent solvent.

### Effects of the Invention

The water-repellent protective film-forming liquid chemical of the present invention is capable of forming a water-repellent protective film on the uneven pattern surface of the wafer without deteriorating the vinyl chloride resin-containing liquid contact part of the wafer cleaning machine. The protective film formed from the water-repellent protective film-forming liquid chemical of the present invention shows high water repellency to lower a capillary force on the uneven pattern surface of the wafer and thereby exert a pattern collapse prevention effect. The use of such a liquid chemical leads to an improvement in the cleaning process during the production of the wafer with the fine uneven pattern without causing a deterioration in throughput. The method of producing the wafer with the fine uneven pattern by using the water-repellent protective film-forming liquid chemical of the present invention is high in productivity.

It is expected that the aspect ratio of wafer circuit patterns will become increasingly higher for high densification of semiconductor devices. The water-repellent protective film-forming liquid chemical of the present invention is applicable to the cleaning of uneven patterns with e.g. an aspect ratio of 7 or higher and enables a cost reduction in the manufacturing of higher-density semiconductor devices. Further, the water-repellent protective film-forming liquid chemical of the present invention is usable in conventional machines without a large change to the liquid contact part and the like, and thus is applicable to the manufacturing of various semiconductor devices.

### Brief Description of the Drawings

FIG. 1 is a schematic plan view of a wafer 1 having on a surface thereof a fine uneven pattern 2.
FIG. 2 is a view showing a part of a-a' cross section of FIG. 1.
FIG. 3 is a schematic view showing a state where a protective film-forming liquid chemical 8 is retained in recess portions 4 of the pattern in a cleaning process.
FIG. 4 is a schematic view showing a state where a liquid is retained in the recess portions 4 on which a protective film has been formed.

### Detailed Description of the Embodiments

### (1) Water-Repellent Protective Film-Forming Liquid Chemical

The water-repellent protective film-forming liquid chemical of the present invention includes:
an alkoxysilane represented by the following general formula [1];
at least one kind selected from the group consisting of a sulfonic acid represented by the following general formula [2], an anhydride of the sulfonic acid, a salt of the sulfonic acid and a sulfonic acid derivative represented by the following general formula [3]; and
a diluent solvent containing, based on 100 mass% of the entire diluent solvent, 80 to 100 mass% of at least one kind selected from the group consisting of hexane, heptane, octane, nonane, decane, dodecane, tetradecane, hexadecane, octadecane, eicosane, cyclohexane, methylcyclohexane, decalin, benzene, toluene, xylene, diethylbenzene, dipropyl ether, ethyl butyl ether, dibutyl ether, ethyl amyl ether, diamyl ether, methyl cyclopentyl ether, ethyl hexyl ether, dihexyl ether, dioctyl ether, diphenyl ether, methyl perfluoropropyl ether, ethyl perfluorobutyl ether, methyl perfluorohexyl ether, ethyl perfluorohexyl ether, 1-hexanethiol, 2-hexanethiol, 3-hexanethiol, 2-methyl-1-pentanethiol,3-methyl-1-pentanethiol, 4-methyl-1-pentanethiol, 2-methyl-2-pentanethiol, 3-methyl-2-pentanethiol, 4-methyl-2-pentanethiol, 2-methyl-3 -pentanethiol, 3-methyl-3-pentanethiol, 2,2-dimethyl-1-butanethiol, 3,3-dimethyl-1-butanethiol, 3,3-dimethyl-2-butanethiol, 2-ethyl-1-butanethiol, 1-heptanethiol, 2-heptanethiol, 3-heptanethiol, 4-heptanethiol, benzylthiol, 1-octanethiol, 2-octanethiol, 3-octanethiol, 4-octanethiol, 2-ethyl-1-hexanethiol, 1-nonanethiol, 2-nonanethiol, 3-nonanethiol, 4-nonanethiol, 5-nonanethiol, 1-decanethiol, 2-decanethiol, 3-decanethiol, 4-decanethiol, 5-decanethiol, tert-decanethiol, 1-undecanethiol, 2-undecanethiol, 3-undecanethiol, 4-undecanethiol, 5-undecanethiol, 6-undecanethiol, 1-dodecanethiol, 2-dodecanethiol, 3-dodecanethiol, 4-dodecanethiol, 5-dodecanethiol, 6-dodecanethiol, tert-dodecanethiol, 1-tridecanethiol, 2-tridecanethiol, 3-tridecanethiol, 4-tridecanethiol, 5-tridecanethiol, 6-tridecanethiol and 7-tridecanethiol, wherein hexane, heptane, octane, nonane, decane, dodecane, tetradecane, hexadecane, octadecane and eicosane may be in the linear form or in the branched form and the ethers may be in the linear form or in the branched form.

   (R¹)*ₐ*Si(H)*_{b}*(OR²)_{4-*a*-*b*} [1]

   In the general formula [1], R¹ is each independently at least one group selected from the group consisting of monovalent C₁-C₁₈ hydrocarbon groups in which a part or all of hydrogen atoms may be substituted with a fluorine atom; R² is each independently a monovalent C₁-C₁₈ hydrocarbon group in which a part or all of hydrogen atoms may be substituted with a fluorine atom; *a* is an integer of 1 to 3; *b* is an integer of 0 to 2; and the sum of *a* and *b* is 3 or smaller.

   R³-S(=O)₂OH [2]

   In the general formula [2], R³ is a group selected from the group consisting of monovalent C₁-C₈ hydrocarbon groups in which a part or all of hydrogen atoms may be substituted with a fluorine atom, and hydroxyl group.

   R³-S(=O)₂O-Si(H)_{3-*c*}(R⁴)*_{c}* [3]

   In the general formula [3], R³ is a monovalent C₁-C₈ hydrocarbon group in which a part or all of hydrogen atoms may be substituted with a fluorine atom; R⁴ is each independently at least one group selected from the group consisting of monovalent C₁-C₁₈ hydrocarbon groups in which a part or all of hydrogen atoms may be substituted with a fluorine atom; and c is an integer of 1 to 3.

In the alkoxysilane, R¹ is a water-repellent functional group. A water-repellent protective film is formed on a surface of a wafer by reacting an alkoxy group (-OR² group) of the alkoxysilane with a silanol group of the wafer surface and fixing the water-repellent functional group on the wafer surface. When the alkoxysilane is used in combination with the at least one kind selected from the group consisting of the sulfonic acid, the anhydride of the sulfonic acid, the salt of the sulfonic acid and the sulfonic acid derivative, it is possible to obtain a water repellency imparting effect by rapid reaction of the alkoxysilane and the wafer surface.

Specific examples of the alkoxysilane are: alkylmethoxysilanes such as CH₃Si(OCH₃)₃, C₂H₅Si(OCH₃)₃, C₃H₇Si(OCH₃)₃, C₄H₉Si(OCH₃)₃, C₅H₁₁Si(OCH₃)₃, C₆H₁₃Si(OCH₃)₃, C₇H₁₅Si(OCH₃)₃, C₈H₁₇Si(OCH₃)₃, C₉H₁₉Si(OCH₃)₃, C₁₀H₂₁Si(OCH₃)₃, C₁₁H₂₃Si(OCH₃)₃, C₁₂H₂₅Si(OCH₃)₃, C₁₃H₂₇Si(OCH₃)₃, C₁₄H₂₉Si(OCH₃)₃, C₁₅H₃₁Si(OCH₃)₃, C₁₆H₃₃Si(OCH₃)₃, C₁₇H₃₅Si(OCH₃)₃, C₁₈H₃₇Si(OCH₃)3, (CH₃)₂Si(OCH₃)₂, C₂H₅Si(CH₃)(OCH₃)₂, (C₂H₅)₂Si(OCH₃)₂, C₃H₇Si(CH₃)(OCH₃)₂, (C₃H₇)₂Si(OCH₃)₂, C₄H₉Si(CH₃)(OCH₃)₂, (C₄H₉)₂Si(OCH₃)₂, C₅H₁₁Si(CH₃)(OCH₃)₂, C₆H₁₃Si(CH₃)(OCH₃)₂, C₇H₁₅Si(CH₃)(OCH₃)₂, C₈H₁₇Si(CH₃)(OCH₃)₂, C₉H₁₉Si(CH₃)(OCH₃)₂, C₁₀H₂₁Si(CH₃)(OCH₃)₂, C₁₁H₂₃Si(CH₃)(OCH₃)₂, C₁₂H₂₅Si(CH₃)(OCH₃)₂, C₁₃H₂₇Si(CH₃)(OCH₃)₂, C₁₄H₂₉Si(CH₃)(OCH₃)₂, C₁₅H₃₁Si(CH₃)(OCH₃)₂, C₁₆H₃₃Si(CH₃)(OCH₃)₂, C₁₇H₃₅Si(CH₃)(OCH₃)₂, C₁₈H₃₇Si(CH₃)(OCH₃)₂, (CH₃)₃SiOCH₃, C₂H₅Si(CH₃)₂OCH₃, (C₂H₅)₂Si(CH₃)OCH₃, (C₂H₅)₃SiOCH₃, C₃H₇Si(CH₃)₂OCH₃, (C₃H₇)₂Si(CH₃)OCH₃, (C₃H₇)₃SiOCH₃, C₄H₉Si(CH₃)₂OCH₃, (C₄H₉)₃SiOCH₃, C₅H₁₁Si(CH₃)₂OCH₃, C₆H₁₃Si(CH₃)₂OCH₃, C₇H₁₅Si(CH₃)₂OCH₃, C₈H₁₇Si(CH₃)₂OCH₃, C₉H₁₉Si(CH₃)₂OCH₃, C₁₀H₂₁Si(CH₃)₂OCH₃, C₁₁H₂₃Si(CH₃)₂OCH₃, C₁₂H₂₅Si(CH₃)₂OCH₃, C₁₃H₂₇Si(CH₃)₂OCH₃, C₁₄H₂₉Si(CH₃)₂OCH₃, C₁₅H₃₁Si(CH₃)₂OCH₃, C₁₆H₃₃Si(CH₃)₂OCH₃, C₁₇H₃₅Si(CH₃)₂OCH₃, C₁₈H₃₇Si(CH₃)₂OCH₃, (CH₃)₂Si(H)OCH₃, CH₃Si(H)₂OCH₃, (C₂H₅)₂Si(H)OCH₃, C₂H₅Si(H)₂OCH₃, C₂H₅Si(CH₃)(H)OCH₃ and (C₃H₇)₂Si(H)OCH₃; fluoroalkylmethoxysilanes such as CF₃CH₂CH₂Si(OCH₃)₃, C₂F₅CH₂CH₂Si(OCH₃)₃, C₃F₇CH₂CH₂Si(OCH₃)₃, C₄F₉CH₂CH₂Si(OCH₃)₃, C₅F₁₁CH₂CH₂Si(OCH₃)₃, C₆F₁₃CH₂CH₂Si(OCH₃)₃, C₇F₁₅CH₂CH₂Si(OCH₃)₃, C₈F₁₇CH₂CH₂Si(OCH₃)₃, CF₃CH₂CH₂Si(CH₃)(OCH₃)₂, C₂F₅CH₂CH₂Si(CH₃)(OCH₃)₂, C₃F₇CH₂CH₂Si(CH₃)(OCH₃)₂, C₄F₉CH₂CH₂Si(CH₃)(OCH₃)₂, C₅F₁₁CH₂CH₂Si(CH₃)(OCH₃)₂, C₆F₁₃CH₂CH₂Si(CH₃)(OCH₃)₂, C₇F₁₅CH₂CH₂Si(CH₃)(OCH₃)₂, C₈F₁₇CH₂CH₂Si(CH₃)(OCH₃)₂, CF₃CH₂CH₂Si(CH₃)₂OCH₃₎ C₂F₅CH₂CH₂Si(CH₃)₂OCH₃, C₃F₇CH₂CH₂Si(CH₃)₂OCH₃, C₄F₉CH₂CH₂Si(CH₃)₂OCH₃, C₅F₁₁CH₂CH₂Si(CH₃)₂OCH₃, C₆F₁₃CH₂CH₂Si(CH₃)₂OCH₃, C₇F₁₅CH₂CH₂Si(CH₃)₂OCH₃, C₈F₁₇CH₂CH₂Si(CH₃)₂OCH₃ and CF₃CH₂CH₂Si(CH₃)(H)OCH₃; compounds obtained by substituting methyl of methoxy moieties of the above methoxysilanes with monovalent C₂-C₁₈ hydrocarbon groups in which a part or all of hydrogen atoms may be substituted with fluorine; and the like.

In terms of the water repellency imparting effect, it is preferable that the R² in the alkoxy group (-OR² group) is of 1 to 12 carbon atoms; and the number of alkoxy groups (-OR² groups) is 1 or 2. It is further preferable that the number of -H groups in the alkoxysilane represented by the general formula [1] is 0 in terms of ease of maintaining water repellency after the formation of the protective film. For these reasons, the alkoxysilane is preferably at least one selected from the group consisting of alkoxysilanes represented by the following general formula [7].

(R¹⁰)*_{d}*Si(OR¹¹)_{4-*d*} [7]

In the general formula [7], R¹⁰ is each independently a monovalent C₁-C₁₈ hydrocarbon group in which a part or all of hydrogen atoms may be substituted with a fluorine atom; R¹¹ is each independently a monovalent C₁-C₁₂ hydrocarbon group; and *d* is 2 or 3.

Among the above specific examples, the alkoxysilane is preferably at least one selected from the group consisting of monoalkoxysilanes represented by the following general formula [8] in terms of the water repellency imparting effect.

(R¹⁰)-Si(CH₃)₂(OR¹¹) [8]

In the general formula [8], R¹⁰ is a monovalent C₁-C₁₈ hydrocarbon group in which a part or all of hydrogen atoms may be substituted with a fluorine atom; and R¹¹ is a monovalent C₁-C₁₂ hydrocarbon group.

Specific examples of the monoalkoxysilanes represented by the above general formula [8] are: alkyldimethylmonoalkoxysilanes such as (CH₃)₃SiOCH₃, C₂H₅Si(CH₃)₂OCH₃, C₃H₇Si(CH₃)₂OCH₃, C₄H₉Si(CH₃)₂OCH₃, C₅H₁₁Si(CH₃)₂OCH₃, C₆H₁₃Si(CH₃)₂OCH₃, C₇H₁₅Si(CH₃)₂OCH₃, C₈H₁₇Si(CH₃)₂OCH₃, CF₃CH₂CH₂Si(CH₃)₂OCH₃, C₂F₅CH₂CH₂Si(CH₃)₂OCH₃, C₃F₇CH₂CH₂Si(CH₃)₂OCH₃, C₄F₉CH₂CH₂Si(CH₃)₂OCH₃, C₅F₁₁CH₂CH₂Si(CH₃)₂OCH₃ and C₆F₁₃CH₂CH₂Si(CH₃)₂OCH₃; compounds obtained by substituting methyl of methoxy moieties of the above alkyldimethylmonoalkoxysilanes with monovalent C₂-C₁₈ hydrocarbon groups; and the like. In terms of the water repellency imparting effect, R¹⁰ is preferably a monovalent C₁-C₈ linear hydrocarbon group in which a part or all of hydrogen atoms may be substituted with a fluorine atom, more preferably a C₁-C₈ unsubstituted linear hydrocarbon group, particularly preferably a methyl group. Further, R¹¹ is preferably a monovalent C₁-C₈ hydrocarbon group of which carbon atom bonded to oxygen is a primary carbon atom. Particularly preferred examples of the monoalkoxysilane are (CH₃)₃SiOCH₃, (CH₃)₃SiOC₂H₅, (CH₃)₃SiOCH₂CH₂CH₃, (CH₃)₃SiOCH₂CH₂CH₂CH₃, (CH₃)₃SiOCH₂CH(CH₃)₂, (CH₃)₃SiOCH₂CH₂CH₂CH₂CH₃, (CH₃)₃SiOCH₂CH₂CH(CH₃)₂, (CH₃)₃SiOCH₂CH₂CH₂CH₂CH₂CH₃, (CH₃)₃SiOCH₂CH₂CH₂CH(CH₃)₂, (CH₃)₃SiOCH₂CH₂CH₂CH₂CH₂CH₂CH₃, (CH₃)₃SiOCH₂CH₂CH₂CH₂CH(CH₃)₂, (CH₃)₃SiOCH₂CH₂CH₂CH₂CH₂CH₂CH₂CH₃, (CH₃)₃SiOCH₂CH₂CH₂CH₂CH₂CH(CH₃)₂ and the like. The alkoxy group of the monoalkoxysilane is preferably of 3 to 8 carbon atoms, more preferably 4 to 8 carbon atoms, in terms of solubility in the at least one kind selected from the group consisting of the sulfonic acid, the anhydride of the sulfonic acid, the salt of the sulfonic acid and the sulfonic acid derivative represented by the general formula [3].

The concentration of the alkoxysilane in the liquid chemical is preferably 0.5 to 35 mass%. When the concentration of the alkoxysilane in the liquid chemical is 0.5 mass% or more, it is easy to obtain the water repellent imparting effect. When the concentration of the alkoxysilane in the liquid chemical is 35 mass% or less, vinyl chloride resin is less likely to be deteriorated. The concentration of the alkoxysilane in the liquid chemical is more preferably 0.7 to 30 mass%, still more preferably 1.0 to 25 mass%. Herein, the concentration of the alkoxysilane in the liquid chemical refers to the amount of the alkoxysilane in units of mass% relative to the total amount of the alkoxysilane represented by the general formula [1], the at least one kind selected from the group consisting of the sulfonic acid represented by the general formula [2], the anhydride of the sulfonic acid, the salt of the sulfonic acid and the sulfonic acid derivative represented by the general formula [3], and the diluent solvent.

The at least one kind selected from the group consisting of the sulfonic acid, the anhydride of the sulfonic acid, the salt of the sulfonic acid and the sulfonic acid derivative promotes the reaction between the alkoxy group (-OR² group) of the alkoxysilane and the silanol group of the wafer surface, and itself may form a part of the protective film. When any acid other than the sulfonic acid, or its anhydride, salt or derivative is used, the liquid chemical does not provide a sufficient water repellency imparting effect or causes deterioration of vinyl chloride resin. Hereinafter, the "at least one kind selected from the group consisting of the sulfonic acid, the anhydride of the sulfonic acid, the salt of the sulfonic acid and the sulfonic acid derivative" is occasionally generically referred to as "sulfonic acid compound".

Specific examples of the sulfonic acid are sulfuric acid, methanesulfonic acid, benzenesulfonic acid, paratoluenesulfonic acid, trifluoromethanesulfonic acid, pentafluoroethanesulfonic acid, hexafluoropropanesulfonic acid, nonafluorobutanesulfonic acid, tridecafluorohexanesulfonic acid and the like. In terms of promotion of the reaction (and by extension, in terms of the water repellency imparting effect), a perfluoroalkyl group is preferred as R³ in the general formula [2]. In terms of environmental influences, a perfluoroalkyl group of 6 carbon atoms or less is more preferred as R³. The sulfonic acid is particularly preferably at least one selected from the group consisting of trifluoromethanesulfonic acid, pentafluoroethanesulfonic acid, heptafluoropropanesulfonic acid, nonafluorobutanesulfonic acid and tridecafluorohexanesulfonic acid.

Specific examples of the sulfuric acid anhydride are anhydrides of the above-exemplified sulfuric acids, and the like. In terms of promotion of the reaction (and by extension, in terms of the water repellency imparting effect), the anhydride of the sulfonic acid where R³ in the general formula [2] is a perfluoroalkyl group is preferred. In terms of environmental influences, the anhydride of the sulfonic acid where R³ is a perfluoroalkyl group of 6 carbon atoms or less is more preferred. The anhydride of the sulfonic acid is particularly preferably at least one selected from the group consisting of trifluoromethanesulfonic acid anhydride, pentafluoroethanesulfonic acid anhydride, heptafluoropropanesulfonic acid anhydride, nonafluorobutanesulfonic acid anhydride and tridecafluorohexanesulfonic acid anhydride.

Specific examples of the sulfuric acid salt are ammonium salts, dimethylamine salts and diethylamine salts of the above-exemplified sulfuric acids. In terms of promotion of the reaction (and by extension, in terms of the water repellency imparting effect), ammonium salt and dimethylamine salt of trifluoromethanesulfonic acid, ammonium salt and dimethylamine salt of pentafluoroethanesulfonic acid, ammonium salt and dimethylamine salt of heptafluoropropanesulfonic acid, ammonium salt and dimethylamine salt of nonafluorobutanesulfonic acid, ammonium salt and dimethylamine salt of tridecafluorohexanesulfonic acid are preferred.

Specific examples of the sulfuric acid derivative are; methanesulfonate silanes such as trimethylsilylmethanesulfonate, dimethylsilylmethanesulfonate, ethyldimethylsilylmethanesulfonate, propyldimethylsilylmethanesulfonate, tripropylsilylmethanesulfonate, butyldimethylsilylmethanesulfonate and octyldimethylsilylmethanesulfonate; compounds obtained by substitution of methyl groups of the above methanesulfonate silanes with an ethyl group, propyl group, butyl group, octyl group, perfluoromethyl group, perfluoroethyl group, perfluoropropyl group or perfluorobutyl group; and the like. In terms of promotion of the reaction (and by extension, in terms of the water repellency imparting effect), preferred are compounds obtained by substitution of methyl groups of the above methanesulfonate silanes with a perfluoromethyl group, perfluoroethyl group, perfluoropropyl group or perfluorobutyl group.

In terms of impurities in the sulfonic acid, the anhydride of the sulfonic acid, the salt of the sulfonic acid and the sulfonic acid derivative, it is preferable to use at least one selected from the group consisting of the sulfonic acid, the anhydride of the sulfonic acid and the sulfonic acid derivative.

The total concentration of the sulfonic acid, the anhydride of the sulfonic acid, the salt of the sulfonic acid and the sulfonic acid derivative in the liquid chemical is preferably 0.0001 to 5 mass%. When the total concentration of the sulfonic acid compound in the liquid chemical is 0.0001 mass% or more, it is easy to obtain the water repellent imparting effect. When the total concentration of the sulfonic acid compound in the liquid chemical is 5 mass% or less, the sulfonic acid compound is less likely to cause erosion of the wafer surface and is less likely to remain as impurities on the wafer surface. In addition, it is unlikely that the liquid chemical will become nonuniform without the sulfonic acid compound being dissolved in the dilute solvent. The total concentration of the sulfonic acid compound in the liquid chemical is more preferably 0.01 to 2 mass%, still more preferably 0.05 to 1 mass%. Herein, the total concentration of the sulfonic acid, the anhydride of the sulfonic acid, the salt of the sulfonic acid and the sulfonic acid derivative in the liquid chemical refers to the total amount of the sulfonic acid, the anhydride of the sulfonic acid, the salt of the sulfonic acid and the sulfonic acid derivative in units of mass% relative to the total amount of the alkoxysilane represented by the general formula [1], the at least one kind selected from the group consisting of the sulfonic acid represented by the general formula [2], the anhydride of the sulfonic acid, the salt of the sulfonic acid and the sulfonic acid derivative represented by the general formula [3], and the diluent solvent.

The at least one kind of solvent selected from the group consisting of the hydrocarbon, the ether and the thiol is a solvent for dissolving therein the alkoxysilane and the at least one kind selected from the group consisting of the sulfonic acid, the sulfonic acid anhydride, the sulfonic acid salt and the sulfonic acid derivative. According to the invention, the hydrocarbon is selected from the group consisting of hexane, heptane, octane, nonane, decane, dodecane, tetradecane, hexadecane, octadecane, eicosane, cyclohexane, methylcyclohexane, decalin, benzene, toluene, xylene and diethylbenzene. Hexane, heptane, octane, nonane, decane, dodecane, tetradecane, hexadecane, octadecane and eicosane are not limited to linear forms and may be in branched forms. The smaller the carbon number of the hydrocarbon, the higher the volatility of the hydrocarbon, the lower the flash point of the hydrocarbon. Thus, it is not preferable to use the hydrocarbon of small carbon number in terms of safety and ease of liquid preparation. On the other hand, the greater the carbon number of the hydrocarbon, the higher the viscosity of the hydrocarbon. It is thus not preferable to use the hydrocarbon of great carbon number in terms of handling ease. For these reasons, the hydrocarbon is preferably of 6 to 13 carbon atoms. More preferably, the hydrocarbon is a C₈-C₁₂ saturated hydrocarbon in terms of safety and viscosity. Particularly preferred are octane, nonane, decane, dodecane, cyclohexane, methylcyclohexane and decalin. As mentioned above, octane, nonane, decane and dodecane are not limited to linear forms and may be in branched forms.

Similarly, the ether of small carbon number is not preferred in terms of safety; and the ether of great carbon number is not preferred in terms of handling ease. For these reasons, according to the invention, the ether is selected from the group consisting of dipropyl ether, ethyl butyl ether, dibutyl ether, ethyl amyl ether, diamyl ether, methyl cyclopentyl ether, ethyl hexyl ether, dihexyl ether, dioctyl ether, diphenyl ether, methyl perfluoropropyl ether, ethyl perfluorobutyl ether, methyl perfluorohexyl ether and ethyl perfluorohexyl ether. These ethers are not limited to linear forms and can be used in branched forms. In terms of resistance to oxidation, ethyl t-butyl ether and methyl cyclopentyl ether are preferred. Methyl perfluoropropyl ether, ethyl perfluorobutyl ether, methyl perfluorohexyl ether and ethyl perfluorohexyl ether are preferred in terms of nonflammability. Dibutyl ether, diamyl ether, dihexyl ether and dioctyl ether are preferred in terms of ease of liquid preparation and high flash point.

The thiol is a compound obtained by substitution of a hydrogen atom of the hydrocarbon with a mercapto group. The thiol of small carbon number is not preferred in terms of safety, environmental influences and the possibility of causing deterioration of vinyl chloride resin. In terms of handling ease, the thiol of great carbon number is not preferred. For these reasons, according to the invention, the thiol is selected from the group consisting of 1-hexanethiol, 2-hexanethiol, 3-hexanethiol, 2-methyl-1-pentanethiol, 3-methyl-1-pentanethiol, 4-methyl-1-pentanethiol, 2-methyl-2-pentanethiol, 3 -methyl-2-pentanethiol, 4-methyl-2-pentanethiol, 2-methyl-3-pentanethiol, 3-methyl-3-pentanethiol, 2,2-dimethyl-1-butanethiol, 3,3-dimethyl-1-butanethiol, 3,3-dimethyl-2-butanethiol, 2-ethyl-1-butanethiol, 1-heptanethiol, 2-heptanethiol, 3-heptanethiol, 4-heptanethiol, benzylthiol, 1-octanethiol, 2-octanethiol, 3-octanethiol, 4-octanethiol, 2-ethyl-1-hexanethiol, 1-nonanethiol, 2-nonanethiol, 3-nonanethiol, 4-nonanethiol, 5-nonanethiol, 1-decanethiol, 2-decanethiol, 3-detanethiol, 4-detanethiol, 5-detanethiol, tert-decanethiol, 1-undecanethiol, 2-undecanethiol, 3-undecanethiol, 4-undecanethiol, 5-undecanethiol, 6-undecanethiol, 1-dodecanethiol, 2-dodecanethiol, 3-dodecanethiol, 4-dodecanethiol, 5-dodecanethiol, 6-dodecanethiol, tert-dodecanethiol, 1-tridecanethiol, 2-tridecanethiol, 3-tridecanethiol, 4-tridecanethiol, 5-tridecanethiol, 6-tridecanethiol and 7-tridecanethiol.

In terms of water repellency imparting effect, the thiol is preferably a primary thiol such as 1-hexanethiol, 2-methyl-1-pentanethiol, 3-methyl-1-pentanethiol, 4-methyl-1-pentanethiol, 2,2-dimethyl-1-butanethiol, 3,3-dimethyl-1-butanethiol, 2-ethyl-1-butanethiol, 1-heptanethiol, benzylthiol, 1-octanethiol, 2-ethyl-1-hexanethiol, 1-nonanethiol, 1-decanethiol, 1-undecanethiol, 1-dodecanethiol or 1-tridecanethiol.

The diluent solvent may contain any organic solvent other than the at least one kind of solvent selected from the group consisting of the hydrocarbon, the ether and the thiol. In terms of prevention of deterioration of vinyl chloride resin and/or in terms of the water repellency imparting effect, the other organic solvent is contained in an amount of less than 20 mass% based on 100 mass% of the entire diluent solvent. The amount of the other organic solvent is preferably less than 10 mass%, more preferably less than 5 mass%, in terms of good balance between the prevention of deterioration of vinyl chloride resin and the water repellency imparting effect. In other words, the at least one kind of solvent selected from the group consisting of the hydrocarbon, the ether and the thiol is contained in a total amount of 80 to 100 mass%, preferably 90 to 100 mass%, more preferably 95 to 100 mass%, based on 100 mass% of the entire diluent solvent.

Examples of the organic solvent other than the at least one kind of solvent selected from the group consisting of the hydrocarbon, the ether and the thiol are esters, ketones, halogen-containing solvents, sulfoxide-based solvents, lactone-based solvents, carbonate-based solvents, alcohols, polyol derivatives and the like. In terms of improvement in the solubility of the sulfonic acid compound, alcohols and polyol derivatives with OH groups are preferred. In terms of the water repellency imparting effect, esters, ketones, halogen-containing solvents and polyol derivatives without OH groups are preferred.

The alkoxysilane and the sulfonic acid in the liquid chemical may be those obtained by reaction, e.g. reaction of a sililation agent and an alcohol as indicated in the following scheme [9].

(R¹)*ₐ*Si(H)_{3-*a*}-OS(=O)₂-R³ + R²OH → (R¹)*ₐ*Si(H)_{3-*a*}-OR² + R³-S(=O)₂-OH [9]

In the above reaction formula, R¹, R² and *a* have the same meanings as in the general formula [1]; and R³ has the same meaning as in the general formula [2].

There is a possibility that the alkoxysilane represented by the general formula [1] may react with the sulfonic acid represented by the general formula [2], the anhydride of the sulfonic acid or the salt of the sulfonic acid to thereby form the sulfonic acid derivative represented by the general formula [3]. Hence, the alkoxysilane represented by the general formula [1], the sulfonic acid represented by the general formula [2], the anhydride of the sulfonic acid or the salt of the sulfonic acid, and the sulfonic acid derivative represented by the general formula [3] may coexist in the liquid chemical of the present invention.

The liquid chemical of the present invention may further contain an additive such as polymerization inhibitor, chain transfer agent, antioxidant or the like in order to increase the stability of the liquid chemical. Examples of the additive are 4-methoxyphenol, dibutylhydroxytoluene, butylhydroxyanisol, 1,4-benzenediol, 2-(1,1-dimethylethyl)-1,4-benzenediol, 1,4-benzoquinone, 1-octanethiol, 1-nonanethiol, 1-decanethiol, 1-undecanethiol, 1-dodecanethiol, octyl-3,5-di-tert-butyl-4-hydroxy-hydrocinnamic acid (available as Irganox 1135 from BASF Corporation), 6-tert-butyl-2,4-xylenol and the like.

In terms of cleanliness of the liquid chemical, the additive is preferably in liquid form. Particularly preferred are 1-dodecanethiol, octyl-3,5-di-tert-butyl-4-hydroxy-hydrocinnamic acid (available as Irganox 1135 from BASF Corporation), 6-tert-butyl-2,4-xylenol and the like, each of which is liquid at e.g. 25°C under atmospheric pressure.

Further, it is preferable that the total amount of water in starting raw materials of the liquid chemical is 2000 mass ppm or less relative to the total amount of the raw materials. When the total amount of water in the raw materials of the liquid chemical exceeds 2000 mass ppm, the effects of the alkoxysilane, the sulfonic acid, the anhydride of the sulfonic acid, the salt of the sulfonic acid and the sulfonic acid derivative may be lowered so that it becomes difficult to form the protective film in a short time. For this reason, it is preferable that the total amount of water in the raw materials of the liquid chemical is as less as possible. The total amount of water in the raw materials of the liquid chemical is more preferably 500 mass ppm or less, still more preferably 200 mass ppm or less. The less amount of water is preferred in view of the fact that the more amount of water present, the more likely the storage stability of the liquid chemical is to be deteriorated. The total amount of water in the raw materials of the liquid chemical is particularly preferably 100 mass ppm or less, more particularly preferably 50 mass ppm or less. Although it is preferable that the total amount of water in the raw materials of the liquid chemical is as less as possible, the total amount of water in the raw materials of the liquid chemical may be 0.1 mass ppm or more as long as it is within the above range. Consequently, it is preferable that the alkoxysilane, the at least one kind selected from the group consisting of the sulfonic acid, the anhydride of the sulfonic acid, the salt of the sulfonic acid and the sulfonic acid derivative, and the diluent solvent in the liquid chemical are low in water content.

It is also preferable that, in a particle measurement made in a liquid phase of the liquid chemical by a light scattering type in-liquid particle detector, the number of particles of diameter larger than 0.2 µm is 100 or less per 1 mL of the liquid chemical. When the number of particles of larger than 0.2 µm exceeds 100 per 1 mL of the liquid chemical, there unfavorably arises a risk of damage to the pattern by the particles. This can lead to a deterioration in device yield and reliability. When the number of particles of larger than 0.2 µm is 100 or less per 1 mL of the liquid chemical, it is favorably feasible to omit or reduce the cleaning of the wafer surface (the surface of the protective film) with a solvent or water after the formation of the protective film. Although it is preferable that the number of particles of larger than 0.2 µm per 1 mL of the liquid chemical is as less as possible, the number of particles of larger than 0.2 µm may be 1 or more per 1 mL of the liquid chemical as long as it is within the above range. In the present invention, the particle measurement in the liquid phase of the liquid chemical can be made by a commercially available measurement device based on a laser light scattering type in-liquid particle measuring method using a laser as a light source. The particle diameter means a light scattering equivalent diameter with reference to a PSL (polystyrene latex) standard particle.

Herein, the particles include particles such as dust, dirt, organic solid matter and inorganic solid matter contained as impurities in the raw materials, and particles such as dust, dirt, organic solid matter and inorganic solid matter introduced as contaminants during preparation of the liquid chemical, and refers to particles finally present without being dissolved in the liquid chemical.

Furthermore, it is preferable that the amount of each of Na, Mg, K, Ca, Mn, Fe, Cu, Li, Al, Cr, Ni, Zn and Ag elements (metal impurities) in the liquid chemical is 0.1 mass ppb or less relative to the total amount of the liquid chemical. When the amount of each metal impurity element in the liquid chemical is more than 0.1 mass ppb relative to the total amount of the liquid chemical, there unfavorably arises a risk of increase in device junction leakage current. This can lead to a deterioration in device yield or reliability. When the amount of each metal impurity element in the liquid chemical is 0.1 mass ppb or less relative to the total amount of the liquid chemical, it is favorably feasible to omit or reduce the cleaning of the wafer surface (the surface of the protective film) with a solvent or water after the formation of the protective film. For this reason, it is preferable that the amount of the metal impurities in the liquid chemical is as less as possible. However, the amount of each metal impurity element in the liquid chemical may be 0.001 mass ppb or more as long as it is within the above range.

The liquid chemical of the present invention may be provided in the form of a water-repellent protective film-forming liquid chemical kit with at least first and second liquids and prepared by mixing of such a liquid chemical kit.

### (2) Water-Repellent Protective Film

In the present invention, the water-repellent protective film refers to a film formed on a wafer surface so as to decrease the wettability of the wafer surface, i.e., impart water repellency to the wafer surface. Further, the water repellency means to decrease a surface energy of an article surface and thereby reduce an interaction such as hydrogen bond or intermolecular force (at an interface) between water or another liquid and the article surface. The water repellency exhibits a great interaction reducing effect against water, but shows a certain interaction reducing effect against a mixed liquid of water and a liquid other than water or against a liquid other than water. The contact angle of the liquid to the article surface can be increased with reduction of the interaction. Herein, the water-repellent protective film may be formed of the alkoxysilane or reaction product containing the alkoxysilane as a main component.

### (3) Wafer

As the wafer, there can be used a wafer having on a surface thereof a film which contains a silicon element in the form of silicon, silicon oxide, silicon nitride or the like, or a wafer having an uneven pattern whose surface at least partially contains a silicon element in the form of silicon, silicon oxide, silicon nitride or the like. Even in the case of using a wafer composed of a plurality of components containing at least a silicon element, the protective film can be formed on surfaces of such silicon element-containing components. The wafer composed of a plurality of components may be those in which silicon element-containing components such as silicon, silicon oxide, silicon nitride and the like are present on the wafer surface, or those in which at least a part of the uneven pattern is composed of silicon element-containing components such as silicon, silicon oxide, silicon nitride and the like. It is herein noted that the area of the wafer where the protective film can be formed from the liquid chemical is a surface of any part of the uneven pattern containing a silicon element.

In general, the wafer having the fine uneven pattern on its surface is obtained by the following procedure. First, a resist with a desired uneven pattern is formed by applying a resist to the smooth surface of the wafer, exposing the resist to light through a resist mask and removing by etching an exposed portion or unexposed portion of the resist. The resist with the uneven pattern may alternatively be formed by pressing a mold with a pattern against the resist. Next, the wafer is subjected to etching. In this etching step, portions of the wafer surface corresponding to the recess portions of the resist pattern is selectively etched. Finally, the resist is removed whereby the wafer with the fine uneven pattern is obtained.

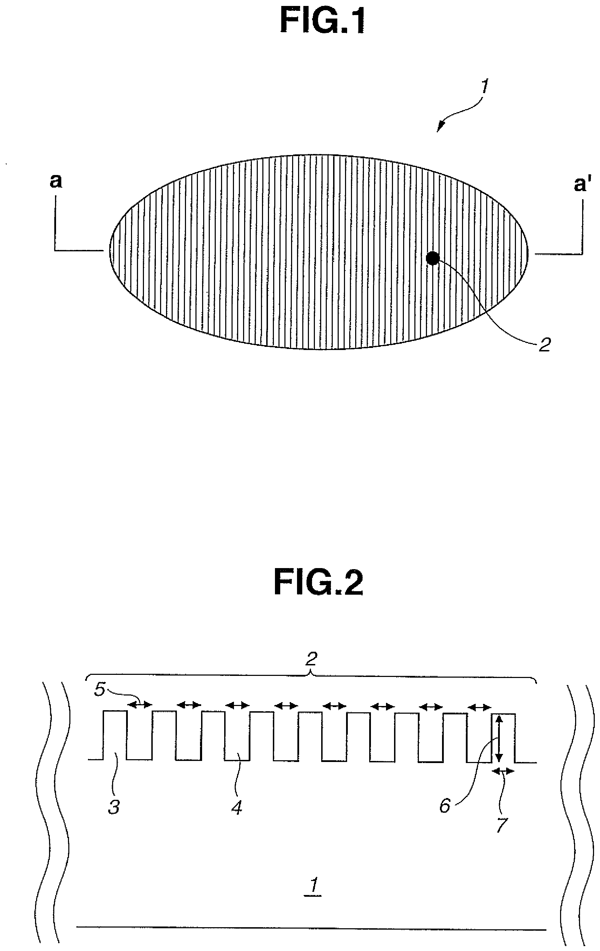

After the formation of the fine uneven pattern on the surface of the wafer, the wafer surface is cleaned with a water-based cleaning liquid; and then the water-based cleaning liquid is removed by drying or the like. The thus-formed pattern is likely to cause a pattern collapse phenomenon when the width of the recess portions is small and the aspect ratio of the projection portions is high. The dimensions of the uneven pattern are defined as shown in FIGS. 1 and 2. FIG. 1 is a schematic plan view of a wafer 1 having on a surface thereof a fine uneven pattern 2. FIG. 2 is a view showing a part of a-a' cross section of FIG. 1. As shown in FIG. 2, a width 5 of the recess portions is determined as an interval between adjacent projection portions 3; and an aspect ratio of the projection portions is determined by dividing a height 6 of the projection portions by a width 7 of the projection portions. The pattern collapse tends to occur in the cleaning process when the width of the recess portions is 70 nm or smaller, particularly 45 nm or smaller, and the aspect ratio of the projection portions is 4 or higher, particularly 6 or higher.

### (4) Wafer Cleaning Method

The wafer, which has a fine uneven pattern formed on its surface by etching as mentioned above, may be cleaned with a water-based cleaning liquid so as to remove etching residues in advance of the wafer cleaning method of the present invention. The wafer may be further cleaned by replacing the water-based cleaning liquid retained in the recess portions after the above cleaning step with a cleaning liquid different from the water-based cleaning liquid (hereinafter referred to as "cleaning liquid A").

As the water-based cleaning liquid, there can be used water or an aqueous solution containing in water at least one kind selected from organic solvent, hydrogen peroxide, ozone, acid, alkali and surfactant (e.g. with a water content of 10 mass% or more)

As the cleaning liquid A, there can be used an organic solvent, a mixture of the organic solvent with a water-based cleaning liquid, or a cleaning liquid containing at least one kind selected from acid, alkali and surfactant in the organic solvent or in the mixture of the organic solvent with the water-based cleaning liquid.

In the present invention, there is no particular limitation on the wafer cleaning technique as long as the cleaning is performed by means of a cleaning machine capable of retaining the liquid chemical or the cleaning liquid at least in the recess portions of the uneven pattern of the wafer. It is feasible to adopt a single wafer process as typified by a process using a spin washing machine in which wafers are cleaned one by one by rotating the wafer in a nearly horizontal position while supplying the liquid to the vicinity of the rotation center, or a batch process in which a plurality of wafers are cleaned together by immersion in the liquid within a cleaning chamber. There is also no particular limitation on the forms of the liquid chemical and the cleaning liquid supplied to at least the recess portions of the uneven pattern of the wafer as long as each of the liquid chemical and the cleaning liquid is in a liquid state when retained in the recess portions. The liquid chemical and the cleaning liquid can be each supplied in e.g. liquid form, vapor form or the like.

Examples of the organic solvent preferably usable as the cleaning liquid A are hydrocarbons, esters, ethers, ketones, halogen-containing solvents, sulfoxide-based solvents, lactone-based solvents, carbonate-based solvents, alcohols, polyol derivatives, nitrogen-containing solvents and the like. Among others, hydrocarbons, ethers, alcohols and polyol derivatives without OH groups and acetate groups are preferred because each of these solvents is unlikely to cause deterioration of vinyl chloride resin. In the case of using the organic solvent as the cleaning liquid A, it is preferable that 80 mass% or more of the total amount of the organic solvent is occupied by the above preferable solvent such as hydrocarbons, ethers, alcohols and polyol derivatives without OH groups and acetate groups.

The protective film-forming liquid chemical of the present invention is used by replacing the water-based cleaning liquid or the cleaning liquid A with the liquid chemical. The replaced liquid chemical may be replaced with a cleaning liquid different from the liquid chemical (hereinafter referred to as "cleaning liquid B").

The wafer cleaning method of the present invention may include, in advance of replacing the water-based cleaning liquid or the cleaning liquid A with liquid chemical, preparing the liquid chemical by mixing the first and second liquids of the water-repellent protective film-forming liquid chemical kit as mentioned above.

After the cleaning of the wafer with the water-based cleaning liquid or after the cleaning of the wafer with the cleaning liquid A, the cleaning liquid is replaced with the protective film-forming liquid chemical. While the liquid chemical is retained at least in the recess portions of the uneven pattern, the protective film is formed on at least the surfaces of the recess portions of the uneven pattern. In the present invention, the protective film is not necessarily continuously formed and is not necessarily uniformly formed. It is however preferable that the protective film is continuously and uniformly formed to impart higher water repellency.

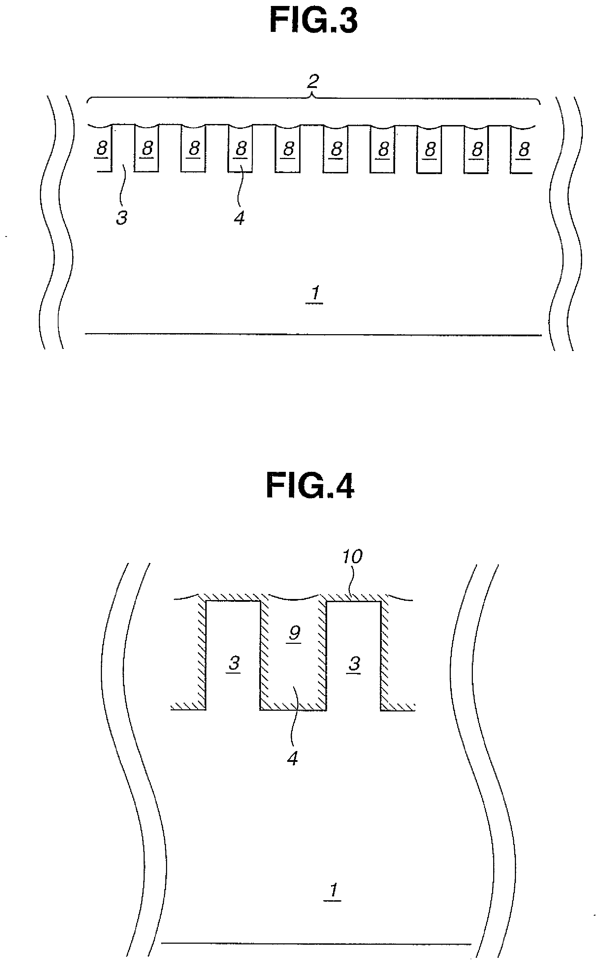

FIG. 3 is a schematic view showing a state where the protective film-forming liquid chemical 8 is retained in the recess portions 4. The schematic view of FIG. 3 shows corresponds to a part of a-a' cross section of FIG. 1. In this state, the protective film is formed on the surfaces of the recess portions 4 so as to impart water repellency to the surfaces of the recess portions 4.

When the temperature of the protective film-forming liquid chemical is increased, the protective film tends to be formed in a shorter time. The temperature at which the uniform protective film can be readily formed is higher than or equal to 10°C and lower than a boiling point of the liquid chemical. In particular, the liquid chemical is preferably retained at a temperature higher than or equal to 15°C and lower than or equal to a temperature 10°C lower than the boiling point of the liquid chemical. It is preferable to maintain the temperature of the liquid chemical at the above-mentioned temperature even when the liquid chemical is retained at least in the recess portions of the uneven pattern. Herein, the boiling point of the liquid chemical means a boiling point of any component present in the largest amount by mass ratio among the components of the protective film-forming liquid chemical.

After the formation of the protective film, the protective film may be subjected to drying after replacing the liquid chemical remaining at least in the recess portions of the uneven pattern with the cleaning liquid B. As the cleaning liquid B, there can be used a water-based cleaning liquid, an organic solvent, a mixture of the water-based cleaning liquid and the organic solvent, a mixture thereof with at least one kind selected from acid, alkali and surfactant, a mixture thereof with the protective film-forming liquid chemical or the like. In terms of removal of particles and metal impurities, the cleaning liquid B is preferably water, an organic solvent or a mixture of the organic solvent with water.

Examples of the organic solvent preferably usable as the cleaning liquid B are hydrocarbons, esters, ethers, ketones, halogen-containing solvents, sulfoxide-based solvents, alcohols, polyol derivatives, nitrogen-containing solvents and the like. Among others, hydrocarbons, ethers, alcohols and polyol derivatives without OH groups and acetate groups are preferred because each of these solvents is unlikely to cause deterioration of vinyl chloride resin. In the case of using the organic solvent as the cleaning liquid B, it is preferable that 80 mass% or more of the total amount of the organic solvent is occupied by the above preferable solvent such as hydrocarbons, ethers, alcohols and polyol derivatives without OH groups and acetate groups.

In the case of using the organic solvent as the cleaning liquid B, there is a case that the protective film formed on the wafer surface from the liquid chemical of the present invention is less likely to be deteriorated in water repellency.

FIG. 4 is a schematic view showing a state where a liquid is retained in the recess portions 4 to which water repellency has been imparted by the protective film forming liquid. The schematic view of FIG. 4 shows corresponds to a part of a-a' cross section of FIG. 1. The surface of the uneven pattern is made water repellent as the protective film 10 is formed on the pattern from the liquid chemical. Even when the liquid 9 is removed from the uneven pattern, the protective film 10 is maintained on the wafer surface.

Assuming that, in a state where the protective film 10 is formed form the protective film-forming liquid chemical at least on the surfaces of the recess portions of the uneven pattern of the wafer, water is retained on the surface of the recess portion, the contact angle is preferably 50 to 130°. In this contact angle range, a pattern collapse is unlikely to occur. The larger the contact angle, the higher the water repellency. The contact angle is more preferably 60 to 130°, still more preferably 65 to 130°. In addition, it is preferable that a decrease of the contact angle before and after the cleaning with the cleaning liquid B (i.e. the contact angle before the cleaning with the cleaning liquid B - the contact angle after the cleaning with the cleaning liquid B) is 10° or less.

Then, the liquid retained in the recess portions 4 on which the protective film 10 has been formed from the liquid chemical is removed by drying. The liquid retained in the recess portions may be the liquid chemical, the cleaning liquid B or a mixed liquid thereof. The mixed liquid is a liquid in which the respective components of the protective film-forming liquid chemical are lower in concentration than those in the liquid chemical. Namely, the mixed liquid may be a liquid in the middle of replacing the liquid chemical with the cleaning liquid B, or may be a liquid prepared in advance by mixing the respective components of the liquid chemical with the cleaning liquid B. In terms of cleanliness of the wafer, water, the organic solvent or a mixture thereof is preferred. After the liquid is once removed from the surface of the uneven pattern, the cleaning liquid B may be retained on the surface of the uneven pattern and then removed by drying.

In the case of cleaning the surface of the uneven pattern with the cleaning liquid B after the formation of the protective film, the cleaning time, that is, the time of retaining the cleaning liquid B is preferably 10 seconds or longer, more preferably 20 seconds or longer, in terms of removal of the particles or impurities from the surface of the uneven pattern. In terms of the water repellency maintaining effect of the protective film formed on the surface of the uneven pattern, there is a tendency that the water repellency of the wafer surface can be easily maintained even after the cleaning when the organic solvent is used as the cleaning liquid B. On the other hand, the productivity of the wafer is deteriorated when the cleaning time is too long. The cleaning time is thus preferably 15 minutes or shorter.

By the drying, the liquid retained in the uneven pattern is removed. It is preferable to perform the drying by a known drying technique such as spin drying, IPA (2-propanol) steam drying, Marangoni drying, heat drying, hot-air drying, air-blow drying or vacuum drying.

After the drying, the protective film 10 may be removed. For removal of the water-repellent protective film, it is effective to cleave C-C bond and C-F bond in the water-repellent protective film. There is no particular limitation on the bond cleavage technique as long as it is capable of cleaving the above-mentioned bond. For example, it is feasible to treat the wafer surface by light irradiation, heating, ozone exposure, plasma irradiation, corona discharge or the like.

In the case of removing the protective film 10 by light irradiation, it is preferable to irradiate an ultraviolet light with wavelengths shorter than 340 nm and 240 nm, which respectively correspond to 83 kcal/mol and 116 kcal/mol, i.e., the bond energies of C-C bond and C-F bond in the protective film 10. As a light source, there can be used a metal halide lamp, a low-pressure mercury lamp, a high-pressure mercury lamp, an excimer lamp, a carbon arc lamp or the like. In the case of using a metal halide lamp, the irradiation intensity of the ultraviolet light is preferably 100 mW/cm² or higher, more preferably 200 mW/cm² or higher, as measured by an illuminometer (such as an irradiation intensity meter UM-10 manufactured by Konica Minolta Sensing, Inc. with a light receptor UM-360 [peak sensitivity wavelength: 365 nm, measurement wavelength range: 310 to 400 nm]). When the irradiation intensity is lower than 100 mW/cm², it takes a long time to remove the protective film 10. It is preferable to use the low-pressure mercury lamp because the low-pressure mercury lamp enables irradiation of an ultraviolet light with shorter wavelengths so as to, even if the irradiation intensity is low, remove the protective film 10 in a short time.

In the case of removing the protective film 10 by light irradiation, it is preferable to generate ozone in parallel with decomposing components of the protective film 10 by irradiation with an ultraviolet light and then induce oxidation volatilization of the components of the protective film 10 by the ozone for shortening of treatment time. As a light source, there can be used a low-pressure mercury lamp, an excimer lamp or the like. The wafer may be heated while being subjected to light irradiation.

In the case of heating the wafer, the heating temperature of the wafer is preferably 400 to 1000°C, more preferably 500 to 900°C; and the heating time of the wafer is preferably 10 seconds to 60 minutes, more preferably 30 seconds to 10 minutes. The heating may be done in combination with ozone exposure, plasma irradiation, corona discharge or the like. The wafer may be subjected to light irradiation while heating.

As the technique of removing the protective film 10 by heating, it is feasible to bring the wafer into a heat source or place the wafer in a heated atmosphere such as heat treatment furnace. Even in the case of treating a plurality of wafers, energy for removal of the protective film 10 can be applied uniformly to the wafer surface by placement in the heated atmosphere. Thus, the placement of the wafer in the heated atmosphere is industrially advantageous in terms of easy operation, short treatment time and high treatment capability.

In the case of exposing the wafer to ozone, it is preferable to supply the wafer surface with ozone generated by ultraviolet radiation from a low-pressure mercury lamp or the like, low-temperature discharge under high voltage application, or the like. The wafer may be subjected to light irradiation or heating while being exposed to ozone.

The protective film on the wafer surface can be efficiently removed by any combination of the light irradiation treatment, the heating treatment, the ozone exposure treatment, the plasma irradiation treatment and the corona discharge treatment.

### Examples

The embodiments of the present invention will be described in more detail below by way of the following examples. It should be understood that the present invention is not limited to the following examples.

A method of forming an uneven pattern on a surface of a wafer and a method of replacing a cleaning liquid retained at least in recess portions of the uneven pattern with another cleaning liquid have been variously studied as discussed in other literatures, and have already been established. Accordingly, the water repellency imparting effect of the protective film-forming liquid chemical and the resistance of vinyl chloride resin to the protective film-forming liquid chemical were evaluated in the present invention. In the following examples, water, which is a typical water-based cleaning liquid, was used as the liquid brought into contact with the wafer surface for evaluation of the contact angle.

In the case of a wafer with an unevenly patterned surface, however, it is not possible to exactly evaluate the contact angle of a protective film 10 itself formed on the unevenly patterned wafer surface.

The contact angle of a water drop is generally evaluated by dropping several microliters of water on a surface of a sample (a substrate) and then measuring an angle between the water drop and the substrate surface according to JIS R 3257 "Testing Method of Wettability of Glass Substrate Surface". However, in the case of a wafer having a pattern, the contact angle is enormously large. This is due to the Wenzel's effect or Cassie's effect by which the apparent contact angle of the water drop becomes increased under the influence of the surface shape (roughness) of the substrate on the contact angle.

In view of the above fact, the following examples were each conducted by providing a wafer with a smooth surface, supplying a protective film-forming liquid chemical to the smooth surface of the wafer to form a protective film on the wafer surface, and then, performing various evaluations on the assumption of the resulting protective film as a protective film formed on an unevenly patterned surface of a wafer. In each example, a silicon wafer having a smooth surface coated with a SiO₂ layer, called a "SiO₂-coated wafer", was used as the wafer with a smooth surface.

The details of the respective examples will be explained below. In the following, explanations will be given of methods for evaluations, a method for preparing a protective film-forming liquid, a method for cleaning a wafer with the use of the protective film-forming liquid chemical and evaluation results.

### [Methods of Evaluations]

The following evaluation tests (A) to (C) were performed.

### (A) Evaluation of Contact Angle of Protective Film on Wafer Surface

About 2 µl of pure water was dropped on the surface of the wafer on which the protective film was formed, followed by measuring the angle between the water drop and the wafer surface (as a contact angle) with a contact angle meter (manufactured by Kyowa Interface Science Co., Ltd.: CA-X Model).

### (B) Evaluation of Decrease of Contact Angle by Contact with Water

After the wafer on which the protective film was formed was immersed in hot water of 60°C, a decrease of the contact angle was evaluated. The smaller the decrease of the contact angle, the more unlikely the contact angle to be decreased by the cleaning step after the formation of the protective film. It is particularly preferable that the decrease of the contact angle is 10° or less.

### (C) Evaluation of Resistance of Vinyl Chloride Resin to Protective Film-Forming Liquid Chemical

In each example, the liquid chemical resistance was evaluated by immersing a vinyl chloride resin in the protective film-forming liquid chemical and checking the occurrence or non-occurrence of a deterioration of the vinyl chloride resin, rather than by cleaning a wafer by a wafer cleaning machine with a vinyl chloride resin-containing liquid contact part and checking the occurrence or non-occurrence of a deterioration of the liquid contact part. More specifically, a vinyl chloride resin sample (with a lustrous surface) was immersed and kept stored in the protective film-forming liquid chemical at 40°C for 4 weeks. After that, the vinyl chloride resin sample was visually observed to examine the occurrence of a deterioration such as discoloration or swelling of the vinyl chloride resin sample. The liquid chemical resistance was judged as pass when there occurred no deterioration of the sample. When there occurred a deterioration of the sample, the liquid chemical resistance was judged as fail.

### [Example 1]

### (1) Preparation of Protective Film-Forming Liquid Chemical

The protective film-forming liquid chemical is prepared by mixing raw materials, that is, 10 g of trimethylmethoxysilane [(CH₃)₃Si-OCH₃] as an alkoxysilane, 0.5 g of methanesulfonic acid [CH₃S(=O)₂OH] as a sulfonic acid compound and 89.5 g of diisoamyl ether [(CH₃)₂CHCH₂CH₂-O-CH₂CH₂CH(CH₃)₂; DiAE] as a diluent solvent.

### (2) Cleaning of Silicon Wafer

The silicon wafer with a smooth thermal oxide film (more specifically, a silicon wafer having on its surface a thermal oxide film of 1 µm thickness) was immersed in a 1 mass % aqueous solution of hydrogen fluoride at room temperature for 10 minutes, immersed in pure water at room temperature for 1 minute, and then, immersed in 2-propanol (iPA) at room temperature for 1 minute.

### (3) Surface Treatment of Silicon Wafer with Protective Film-Forming Liquid Chemical

The above-cleaned silicon wafer was immersed in the protective film-forming liquid chemical, which was prepared in the above section "(1) Preparation of Protective Film-Forming Liquid Chemical", at room temperature for 2 minutes. After that, the silicon wafer was immersed in iPA at room temperature for 1 minute and immersed in pure water at room temperature for 1 minute. Finally, the silicon wafer was taken out from the pure water and dried by air blowing to remove the pure water on the surface of the silicon wafer.

Then, the evaluation tests (A) to (C) were performed as mentioned above. As shown in TABLE 1, the initial contact angle before the surface treatment was less than 10° and the contact angle after the surface treatment was 76°. As is apparent from these results, the protective film had an effect of imparting water repellency to the wafer substrate. As the decrease of the contact angle was 2°, the water repellency was favorably easily maintained. Further, the resistance of the vinyl chloride resin was good as there was no change in appearance even after the storage in the liquid chemical at 40°C for 4 weeks.

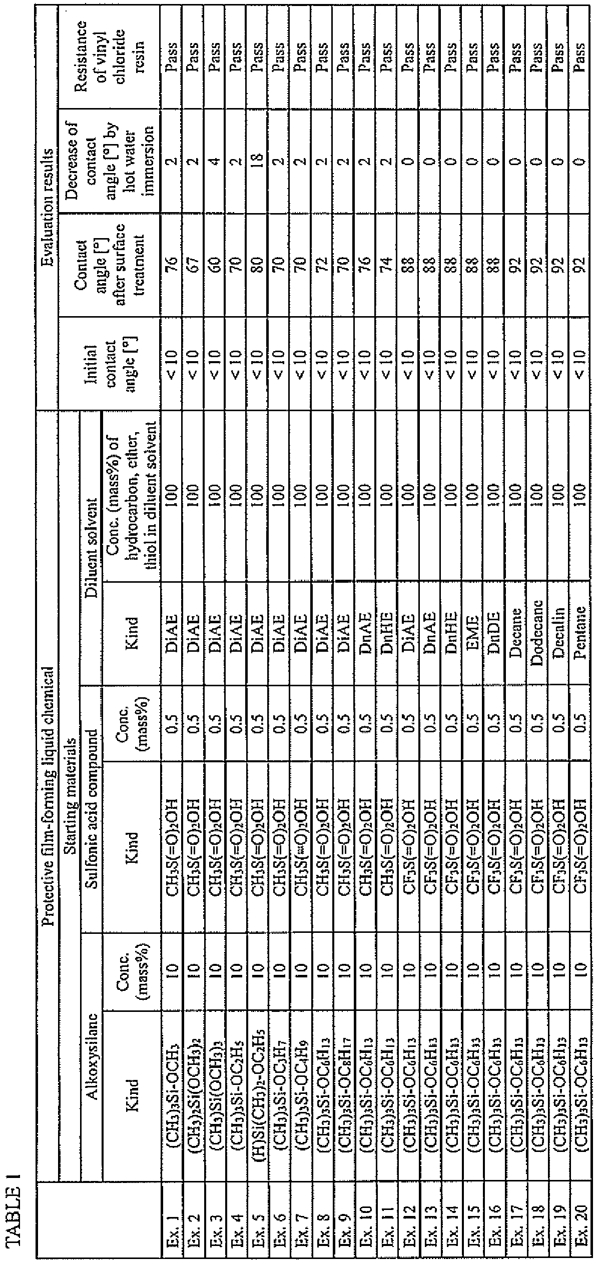

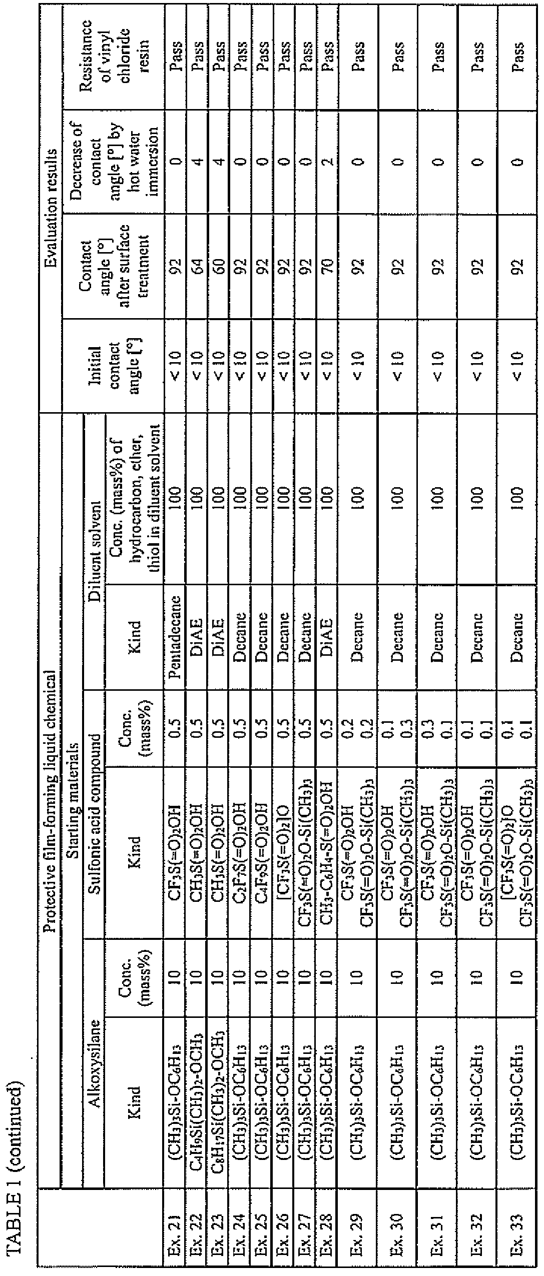

### [Examples 2 to 83]

The wafer surface treatment was performed in the same manner as in Example 1, except for changing liquid chemical preparation conditions such as the kind and concentration of the alkoxysilane, the kind and concentration of the sulfonic acid compound and the kind of the diluent solvent. After that, the evaluation tests were performed in the same manner as above. The results are summarized in TABLES 1 to 3. In the respective tables, "DnAE" means dinormalamyl ether; "DnHE" means dinormalhexyl ether; "EME" means ethyl methyl ether; "DnDE" means dinormaldecyl ether; "DiAE/PGMEA-95" means a mixed solvent of DiAE and PGMEA (propylene glycol monomethyl ether acetate) at a mass ratio of 95:5; "DiAE/PGMEA-90" means a mixed solvent of DiAE and PGMEA at a mass ratio of 90:10; "DiAE/nHA-95" means a mixed solvent of DiAE and nHA (n-hexanol) at a mass ratio of 95:5; "DiAE/ethyl acetate-95" means a mixed solvent of DiAE and ethyl acetate at a mass ratio of 95:5; "DiAE/cyclohexanone-95" means a mixed solvent of DiAE and cyclohexanone at a mass ratio of 95:5; "decane/PGMEA-95" means a mixed solvent of decane and PGMEA at a mass ratio of 95:5; "decane/nHA-95" means a mixed solvent of decane and nHA at a mass ratio of 95:5; "decane/nHA-90" means a mixed solvent of decane and nHA at a mass ratio of 90:10; decane and nHA; "1-dodecanethiol/PGMEA-95" means a mixed solvent of 1-dodecanethiol and PGMEA at a mass ratio of 95:5; "1-dodecanethiol/PGMEA-90" means a mixed solvent of 1-dodecanethiol and PGMEA at a mass ratio of 90:10; "1-dodecanethiol/nHA-95" means a mixed solvent of 1-dodecanethiol and nHA at a mass ratio of 95:5; "1-dodecanethiol/nHA-90" means a mixed solvent of 1-dodecanethiol and nHA at a mass ratio of 90:10; "1-dodecanethiol/ethyl acetate-95" means a mixed solvent of 1-dodecanethiol and ethyl acetate at a mass ratio of 95:5; and "1-dodecanethiol/cyclohexanone-95" means a mixed solvent of 1-dodecanethiol and cyclohexanone at a mass ratio of 95:5.
Examples 15, 20 and 21 are not according to the invention.

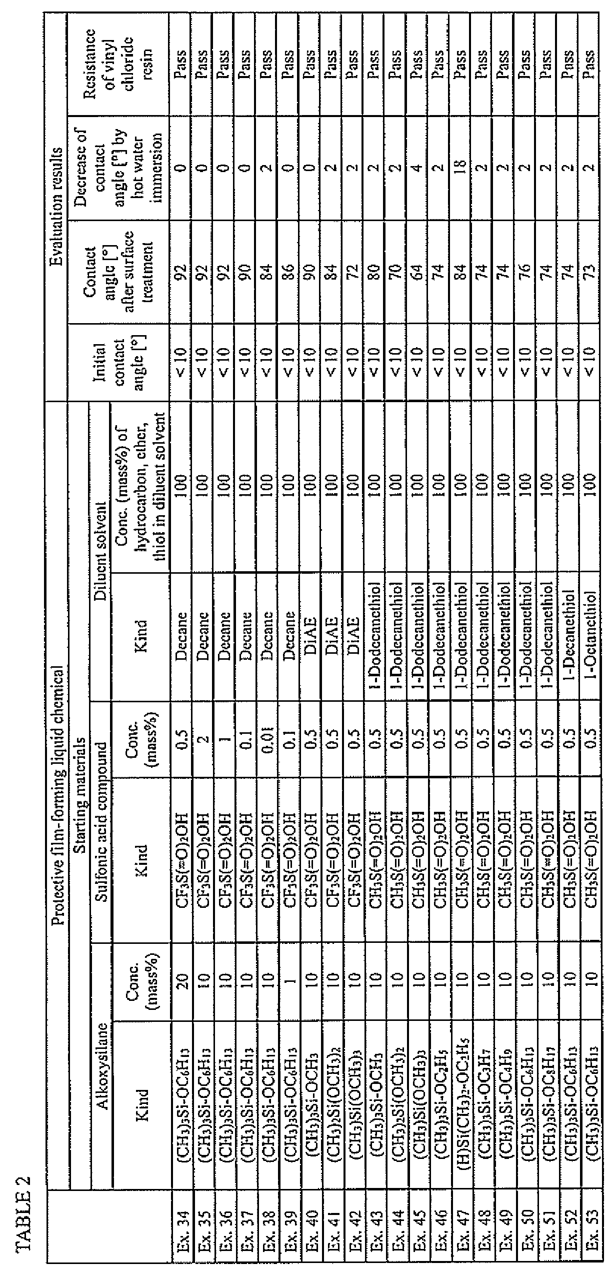

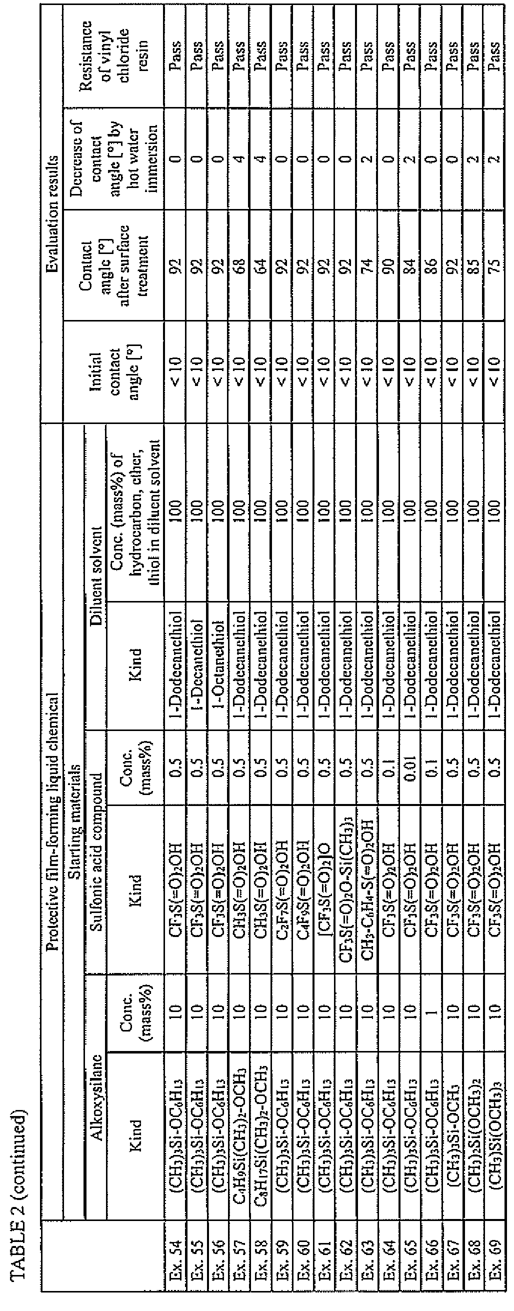

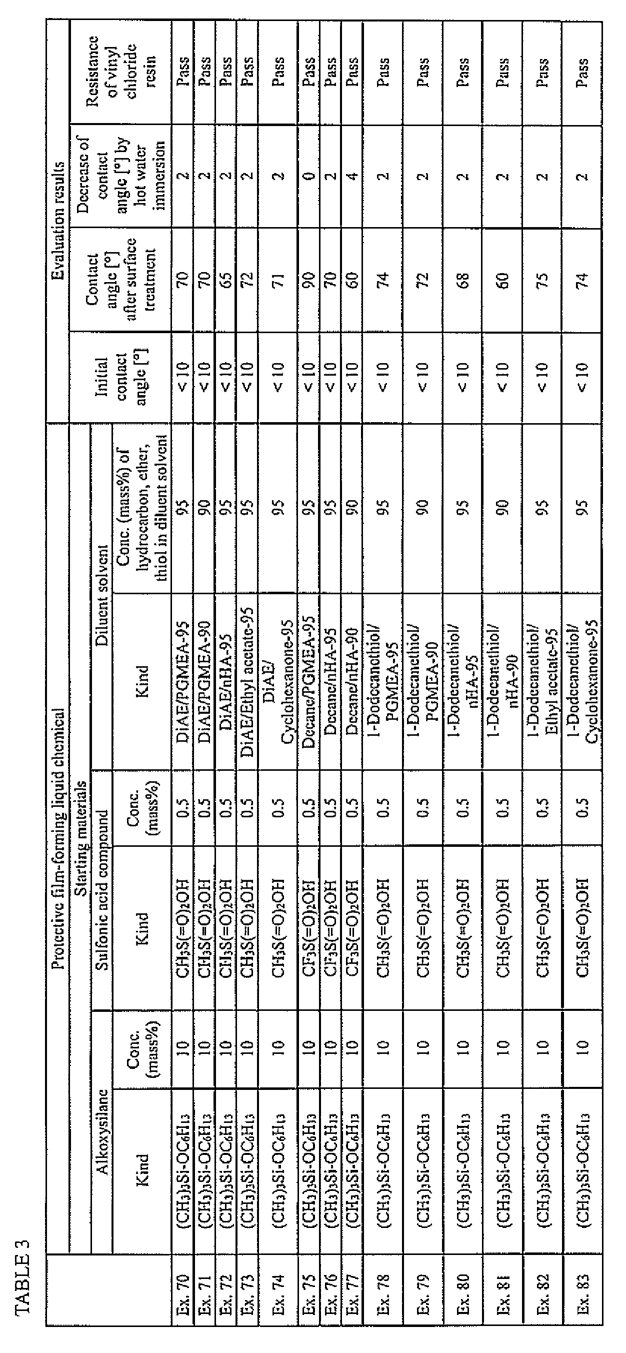

In each example, the initial contact angle before the surface treatment was less than 10°; and the contact angle became larger after the surface treatment. Thus, the protective film had an effect of imparting water repellency to the wafer surface. As the decrease of the contact angle was slight, the water repellency was favorably easily maintained. Further, the resistance of the vinyl chloride resin was good as there was no change in appearance even after the storage in the liquid chemical at 40°C for 4 weeks.

In Example 5, the alkoxysilane used was of the kind where one hydrogen atom was bonded to a silicon atom (that is, *b* in the general formula [1] was 1). In Example 4, on the other hand, the alkoxysilane used was of the kind where *b* in the general formula [1] was 0. There was observed a tendency that the decrease of the contact angle by contact with water was larger in Example 5 than in Example 4. It is understood from these results that, in terms of the ease of maintaining water repellency after the formation of the protective film, it is preferred that the number of -H groups in the alkoxysilane represented by the general formula [1] is 0.

As is seen from comparison of Examples 1, 22 and 23, the smaller the carbon number of the hydrocarbon group R¹ in the general formula [1], the larger the contact angle after the surface treatment. In particular, a better water repellency was obtained when R¹ was a methyl group.

As is seen from comparison of Examples 1, 2 and 3, the contact angle after the surface treatment was in the order of Example 1 > Example 2 > Example 3 (monoalkoxysilane > dialkoxysilane > trialkoxysilane). Namely, a monoalkoxysilane was preferred in terms of the water repellency imparting effect. The same tendency was observed in comparison of Examples 40, 41 and 42.

As is seen from comparison of Examples 8 and 12, a better water repellency imparting effect was obtained when R³ in the general formula [2] was a perfluoroalkyl group. Further, a good water repellency imparting effect was obtained in each of Examples 17, 24 and 25 in which the sulfonic acid compound used was a sulfonic acid having a perfluoroalkyl group as R³ in the general formula [2].

In Example 26, the sulfonic acid compound used was an anhydride of the sulfonic acid of Example 17. In this example, a good water repellency imparting effect was also obtained.

In Example 27, the sulfonic acid compound used was a sulfonic acid derivative in which -OH group of trifluoromethanesulfonic acid was substituted with -OSi(CH₃)₃ group. In this example, a good water repellency imparting effect was also obtained.

In Examples 29 to 32, two kinds of sulfonic acid compounds, that is, trifluoromethanesulfonic acid and the sulfonic acid derivative of Example 27 were used. In each of these examples, a good water repellency imparting effect was obtained. In Example 33, two kinds of sulfonic acid compounds, that is, the sulfonic acid anhydride of Example 26 and the sulfonic acid derivative of Example 27 were used. A good water repellency imparting effect was also obtained in this example.

In Examples 12, 13 and 14, DiAE, DnAE and DnHE were respectively used as the diluent solvent. The evaluation results of these examples were favorable. In Example 15, EME was used as the diluent solvent. Although the evaluation results of this example were favorable, the diluent solvent was high in volatility so that it was necessary to prepare the liquid chemical under cooling in order to suppress a change in concentration caused due to volatilization of the diluent solvent. In Example 16, DnDE was used as the diluent solvent. Although the evaluation results of this example were favorable, the diluent solvent was high in viscosity so that the stirring time tended to be long to obtain the uniform water-repellent protective film-forming liquid chemical.

In Examples 17, 18 and 19, decane, dodecane and decalin were respectively used as the diluent solvent. The evaluation results of these examples were favorable. In Example 20, pentane was used as the diluent solvent. Although the evaluation results of this example were favorable, the diluent solvent was high in volatility so that it was necessary to prepare the liquid chemical under cooling in order to suppress a change in concentration caused due to volatilization of the diluent solvent. In Example 21, pentadecane was used as the diluent solvent. Although the evaluation results of this example were favorable, the diluent solvent was high in viscosity so that the stirring time tended to be long to obtain the uniform water-repellent protective film-forming liquid chemical.

In Examples 43 to 69 in which a thiol was used as the diluent solvent, the same tendency as above was observed.

Further, the evaluation results were favorable in each of Examples 70 to 83 in which a mixed solvent was used as the diluent solvent.

### [Examples 84 to 89]

In Examples 84 and 85, liquid chemicals were prepared by adding 1-dodecanethiol as an additive at a concentration of 1 mass% to the liquid chemicals of Examples 17 and 75, respectively. The evaluation results of these examples were favorable. In Examples 86 and 87, liquid chemicals were prepared by adding BHT (dibutylhydroxytoluene) as an additive at a concentration of 0.1 mass% to the liquid chemicals of Examples 17 and 75, respectively. The evaluation results of these examples were also favorable. In Examples 88 and 89, liquid chemicals were prepared by adding tert-buthylxylenol (6-tert-butyl-2,4-xylenol) as an additive at a concentration of 0.1 mass% to the liquid chemicals of Examples 17 and 75, respectively. The evaluation results of these examples were also favorable. The results are summarized in TABLE 4.

**TABLE 4**

| | Protective film-forming liquid chemical | | | | | | Other additive | Evaluation results | | | |
|---|---|---|---|---|---|---|---|---|---|---|---|
| | Starling materials | | | | | | | Initial contact angle [°] | Contact angle [°] after surface treatment | Decrease of contact angle [°] by hot water immersion | Resistance of vinyl chloride resin |
| | Alkoxysilane | | Sulfonic acid compound | | Diluent solvent | | | | | | |
| | Kind | Conc. (mass%) | Kind | Conc. (mass%) | Kind | Conc. (mass%) of hydrocarbon, ether, thiol in diluent solvent | | | | | |
| Ex. 84 | (CR₃)₃Si-OC₆H₁₃ | 10 | CF₃S(=O)₂OH | 0.5 | Decane | 100 | 1-Dodecanethiol | < 10 | 92 | 0 | Pass |
| Ex. 85 | (CH₃)₃Si-OC₆H₁₃ | 10 | CF₃S(=O)₂OH | 0.5 | Decane/ PGMEA-95 | 95 | 1-Dodecanethiol | < 10 | 90 | 0 | Pass |
| Ex. 86 | (CH₃)₃Si-OC₆H₁₃ | 10 | CF₃S(=O)₂OH | 0.5 | Decane | 100 | BHT | < 10 | 92 | 0 | Pass |
| Ex. 87 | (CH₃)₃Si-OC₆H₁₃ | 10 | CF₃S(=O)₂OH | 0.5 | Decane/ PGMEA-95 | 95 | BHT | < 10 | 90 | 0 | Pass |
| Ex. 88 | (CH₃)₃Si-OC₆H₁₃ | 10 | CF₃S(=O)₂OH | 0.5 | Decane | 100 | Tert-butyl xylenol | < 10 | 92 | 0 | Pass |
| Ex. 89 | (CH₃)₃Si-OC₆H₁₃ | 10 | CF₃S(=O)₂OH | 0.5 | Decane/ PGMEA-95 | 95 | Tert-butyl xylenol | < 10 | 90 | 0 | Pass |

### [Example 90]

### (Preparation of First Liquid)

A first liquid was prepared by mixing 10 g of trimethylmethoxysilane as an alkoxysilane with 40 g of diisoamyl ether as a diluent solvent.

### (Preparation of Second Liquid)

A second liquid was prepared by mixing 0.5 g of a sulfonic acid derivative in which -OH group of trifluoromethanesulfonic acid was substituted with -OSi(CH₃)₃ group [CF₃S(=O)₂O-Si(CH₃)₃] as a sulfonic acid compound with 49.5 g of diisoamyl ether as a diluent solvent.

The wafer surface treatment and evaluation tests were performed in the same manner as in Example 1 except that a protective film-forming liquid chemical was preparing by mixing the above first and second liquids.

Then, the evaluation tests (A) to (C) were performed as mentioned above. As shown in TABLE 5, the initial contact angle before the surface treatment was less than 10°; and the contact angle after the surface treatment was 87°. As is apparent from these results, the protective film had an effect of imparting water repellency to the wafer substrate. As the decrease of the contact angle was 0°, the water repellency was favorably easily maintained. Further, the resistance of the vinyl chloride resin was good as there was no change in appearance even after the storage in the liquid chemical at 40°C for 4 weeks.

**TABLE 5**

| | Protective film-forming liquid chemical | | | | | | | | Evaluation results | | | |
|---|---|---|---|---|---|---|---|---|---|---|---|---|
| | Starting materials | | | | | | | | Initial contact angle [°] | Contact angle [°] after surface treatment | Decrease of contact angle [°] by hot water immersion | Resistance of vinyl chloride resin |
| | First liquid | | | | Second liquid | | | | | | | |
| | Alkoxysilane | | Diluent solvent | | Sulfonic acid compound | | Diluent solvent | | | | | |
| | Kind | Conc. (mass%) in first liquid | Kind | Conc. (mass%) of hydrocarbon, ether, thiol in diluent solvent of first liquid | Kind | Conc. (mass%) in second liquid | Kind | Conc. (mass%) of hydrocarbon, ether, thiol in diluent solvent of second liquid | | | | |
| Ex. 90 | (CH₃)₃Si-OCH₃ | 20 | DiAE | 100 | CF₃S(=O)₂O-Si(CH₃)₃ | 1 | DiAE | 100 | < 10 | 87 | 0 | Pass |
| Ex. 91 | (CH₃)₃Si-OC₆H₁₃ | 20 | DiAE | 100 | CF₃S(=O)₂O-Si(CH₃)₃ | 1 | DiAE | 100 | < 10 | 88 | 0 | Pass |
| Ex. 92 | (CH₃)₃Si-OC₆H₁₃ | 20 | Decane | 100 | CF₃S(=O)₂O-Si(CH₃)₃ | 1 | Decane | 1 00 | < 10 | 93 | 0 | Pass |
| Ex. 93 | (CH₃)₃Si-OC₆H₁₃ | 20 | Decane | 100 | CF₃S(=O)₂O-Si(CH₃)₃ | 0.2 | Decane | 100 | < 10 | 91 | 0 | Pass |
| Ex. 94 | (CH₃)₃Si-OC₆H₁₃ | 2 | Dccanc | 100 | CF₃S(=O)₂O-Si(CH₃)₃ | 0.2 | Dccnne | 100 | < 10 | 87 | 0 | Pass |

### [Examples 91 to 94]

The wafer surface treatment was performed in the same manner as in Example 90, except for changing liquid chemical preparation conditions such as the kind and concentration of the alkoxysilane, the concentration of the sulfonic acid compound and the kind of the diluent solvent. After that, the evaluation tests were performed in the same manner as above. The results are summarized in TABLE 5.

In each example, the initial contact angle before the surface treatment was less than 10°; and the contact angle became larger after the surface treatment. Thus, the protective film had an effect of imparting water repellency to the wafer surface. As the decrease of the contact angle was slight, the water repellency was favorably easily maintained. Further, the resistance of the vinyl chloride resin was good as there was no change in appearance even after the storage in the liquid chemical at 40°C for 4 weeks.

### [Comparative Examples 1 to 12]

The wafer surface treatment was performed in the same manner as in Example 1, except for changing liquid chemical preparation conditions such as the kind and concentration of the sulfonic acid compound and the kind of the diluent solvent as shown in TABLE 6. After that, the evaluation tests were performed in the same manner as above.

In Comparative Example 1 in which no sulfonic acid was contained in the protective film-forming liquid chemical, the contact angle after the surface treatment was a small value of less than 10°. No water repellency imparting effect was observed.

In Comparative Example 2, DiAE was used in place of the diluent solvent of Comparative Example 1. The evaluation results of Comparative Example 2 were similar to those of Comparative Example 1. In Comparative Example 3, 1-dodecanethiol was used in place of the diluent solvent of Comparative Example 1. The evaluation results of Comparative Examples 3 were also similar to those of Comparative Example 1.

In Comparative Examples 4 to 12, the total amount of the hydrocarbon, the ether and the thiol was 70 mass% based on 100 mass% of the entire diluent solvent in the protective film-forming liquid chemical. In the evaluation test of the resistance of the vinyl chloride resin to the protective film-forming liquid chemical, swelling of the vinyl chloride resin was observed after the storage. Thus, the liquid chemical resistance was judged as fail.

**TABLE 6**

| | Protective film-forming liquid chemical | | | | | | Evaluation results | | | |
|---|---|---|---|---|---|---|---|---|---|---|
| | Starting materials | | | | | | Initial contact angle [°] | Contact angle [°] after surface treatment | Decrease of contact angle [°] by hot water immersion | Resistance of vinyl chloride resin |
| | Alkoxysilane | | Sulfonic acid compound | | Diluent solvent | | | | | |
| | Kind | Conc. (mass%) | Kind | Conc. (mass%) | Kind | Conc. (mass%) of hydrocarbon, ether, thiol in diluent solvent | | | | |
| Comp. Ex. 1 | (CH₃)₃Si-OCH₃ | 10 | - | - | Decane | 100 | <10 | < 10 | 0 | Pass |
| Comp. Ex. 2 | (CH₃)₃Si-OCH₃ | 10 | - | - | DiAE | 100 | < 10 | < 10 | 0 | Pass |
| Comp. Ex. 3 | (CH₃)₃Si-OCH₃ | 10 | - | - | 1-Dodecanethiol | 100 | < 10 | < 10 | 0 | Pass |
| Comp. Ex. 4 | (CH₃)₃Si-OCH₃ | 10 | CF₃S(=O)₂OH | 0.5 | Decane/PGMEA-70 | 70 | < 10 | 90 | 0 | Fail |
| Comp. Ex. 5 | (CH₃)₃Si-OCH₃ | 10 | CF₃S(=O)₂OH | 0.1 | Decane/PGMEA-70 | 70 | < 10 | 90 | 0 | Fail |
| | | | CF₃S(=O)₂O-Si(CH₃)₃ | 0.1 | | | | | | |
| Comp. Ex. 6 | (CH₃)₃Si-OCH₃ | 10 | [CF₃S(=O)₂]O | 0.1 | Decane/PGMEA-70 | 70 | < 10 | 90 | 0 | Fail |
| | | | CF₃S(=O)₂O-Si(CH₃)₃ | 0.1 | | | | | | |
| Comp. Ex. 7 | (CH₃)₃Si-OCH₃ | 10 | CF₃S(=O)₂OH | 0.5 | DiAE/PGMEA-70 | 70 | < 10 | 87 | 2 | Fail |
| Comp. Ex. 8 | (CH₃)₃Si-OCH₃ | 10 | CF₃S(=O)₂OH | 0.5 | DiAE/Ethyl acetate-70 | 70 | < 10 | 90 | 0 | Fail |
| Comp. Ex. 9 | (CH₃)₃Si-OCH₃ | 10 | CF₃S(=O)₂OH | 0.5 | DiAE/Cyclohexanone-70 | 70 | < 10 | 72 | 2 | Fail |
| Comp. Ex. 10 | (CH₃)₃Si-OCH₃ | 10 | CF₃S(=O)₂OH | 0.5 | 1-Dodecanethiol/PGMEA-70 | 70 | <10 | 90 | 0 | Fail |
| Comp. Ex. 11 | (CH₃)₃Si-OCH₃ | 10 | CF₃S(=O)₂OH | 0.5 | 1-Dodecanethiol/Ethyl acetate-70 | 70 | < 10 | 90 | 0 | Fail |
| Comp. Ex. 12 | (CH₃)₃Si-OCH₃ | 10 | CF₃S(=O)₂OH | 0.5 | 1-Dodecanethiol/Cyclohexanone-70 | 70 | < 10 | 72 | 2 | Fail |

### Description of Reference Numerals

- 1:: Wafer
- 2:: Fine uneven pattern on wafer surface
- 3:: Projection portion of pattern
- 4:: Recess portion of pattern
- 5:: Width of recess portion
- 6:: Height of projection portion
- 7:: Width of projection portion
- 8:: Protective film-forming liquid chemical retained in recess portion 4
- 9:: Liquid retained in recess portion 4
- 10:: Protective film

## Claims

1. A wafer cleaning method for cleaning a wafer by means of a wafer cleaning machine, the wafer having on a surface thereof a fine uneven pattern at least partially containing a silicon element, the wafer cleaning machine having a liquid contact part containing a vinyl chloride resin,
the method comprising retaining a water-repellent protective film-forming liquid chemical at least in a recess portion of the uneven pattern, thereby forming a water-repellent protective film on a surface of the recess portion,
the water-repellent protective film-forming liquid chemical comprising:
an alkoxysilane represented by the following general formula [1];
at least one kind selected from the group consisting of a sulfonic acid represented by the following general formula [2], an anhydride of the sulfonic acid, a salt of the sulfonic acid and a sulfonic acid derivative represented by the following general formula [3]; and
a diluent solvent,
(R¹)*ₐ*Si(H)*_{b}*(OR²)_{4-*a*-*b*} [1]
where R¹ is each independently at least one group selected from the group consisting of monovalent C₁-C₁₈ hydrocarbon groups in which a part or all of hydrogen atoms may be substituted with a fluorine atom; R² is each independently a monovalent C₁-C₁₈ hydrocarbon group in which a part or all of hydrogen atoms may be substituted with a fluorine atom; *a* is an integer of 1 to 3; *b* is an integer of 0 to 2; and a sum of *a* and *b* is 3 or smaller,
R³-S(=O)₂OH [2]
where R³ is a group selected from the group consisting of monovalent C₁-C₈ hydrocarbon groups in which a part or all of hydrogen atoms may be substituted with a fluorine atom, and hydroxyl group,
R³-S(=O)₂O-Si(H)_{3-*c*}(R⁴)*_{c}* [3]
where R³ is a monovalent C₁-C₈ hydrocarbon group in which a part or all of hydrogen atoms may be substituted with a fluorine atom; R⁴ is each independently at least one group selected from the group consisting of monovalent C₁-C₁₈ hydrocarbon groups in which a part or all of hydrogen atoms may be substituted with a fluorine atom; and c is an integer of 1 to 3,
**characterized in that**:
the diluent solvent contains, based on 100 mass% of the entire diluent solvent, 80 to 100 mass% of at least one kind selected from the group consisting of hexane, heptane, octane, nonane, decane, dodecane, tetradecane, hexadecane, octadecane, eicosane, cyclohexane, methylcyclohexane, decalin, benzene, toluene, xylene, diethylbenzene, dipropyl ether, ethyl butyl ether, dibutyl ether, ethyl amyl ether, diamyl ether, methyl cyclopentyl ether, ethyl hexyl ether, dihexyl ether, dioctyl ether, diphenyl ether, methyl perfluoropropyl ether, ethyl perfluorobutyl ether, methyl perfluorohexyl ether, ethyl perfluorohexyl ether, 1-hexanethiol, 2-hexanethiol, 3-hexanethiol, 2-methyl-1-pentanethiol, 3-methyl-1-pentanethiol, 4-methyl-1-pentanethiol, 2-methyl-2-pentanethiol, 3-methyl-2-pentanethiol, 4-methyl-2-pentanethiol, 2-methyl-3-pentanethiol, 3-methyl-3-pentanethiol, 2,2-dimethyl-1-butanethiol, 3,3-dimethyl-1-butanethiol, 3,3-dimethyl-2-butanethiol, 2-ethyl-1-butanethiol, 1-heptanethiol, 2-heptanethiol, 3-heptanethiol, 4-heptanethiol, benzylthiol, 1-octanethiol, 2-octanethiol, 3-octanethiol, 4-octanethiol, 2-ethyl-1-hexanethiol, 1-nonanethiol, 2-nonanethiol, 3-nonanethiol, 4-nonanethiol, 5-nonanethiol, 1-decanethiol, 2-decanethiol, 3-decanethiol, 4-decanethiol, 5-decanethiol, tert-decanethiol, 1-undecanethiol, 2-undecanethiol, 3-undecanethiol, 4-undecanethiol, 5-undecanethiol, 6-undecanethiol, 1-dodecanethiol, 2-dodecanethiol, 3-dodecanethiol, 4-dodecanethiol, 5-dodecanethiol, 6-dodecanethiol, tert-dodecanethiol, 1-tridecanethiol, 2-tridecanethiol, 3-tridecanethiol, 4-tridecanethiol, 5-tridecanethiol, 6-tridecanethiol and 7-tridecanethiol, wherein hexane, heptane, octane, nonane, decane, dodecane, tetradecane, hexadecane, octadecane and eicosane may be in the linear form or in the branched form and the ethers may be in the linear form or in the branched form.

2. The wafer cleaning method according to claim 1, wherein the diluent solvent contains, based on 100 mass% of the entire diluent solvent, 80 to 100 mass% of at least one kind selected from the group consisting of octane, nonane, decane, dodecane, cyclohexane, methylcyclohexane, decalin, ethyl t-butyl ether, methyl cyclopentyl ether, methyl perfluoropropyl ether, ethyl perfluorobutyl ether, methyl perfluorohexyl ether, ethyl perfluorohexyl ether, dibutyl ether, diamyl ether, dihexyl ether, dioctyl ether, 1-hexanethiol, 2-methyl-1-pentanethiol, 3-methyl-1-pentanethiol, 4-methyl-1 -pentanethiol, 2,2-dimethyl-1 -butanethiol, 3,3-dimethyl-1 -butanethiol, 2-ethyl-1-butanethiol, 1-heptanethiol, benzylthiol, 1-octanethiol, 2-ethyl-1-hexanethiol, 1-nonanethiol, 1-decanethiol, 1-undecanethiol, 1-dodecanethiol and 1-tridecanethiol.

3. The wafer cleaning method according to claim 2, wherein the diluent solvent contains, based on 100 mass% of the entire diluent solvent, 80 to 100 mass% of at least one kind selected from the group consisting of diamyl ether, dihexyl ether, decane, dodecane, decalin, 1-dodecanethiol, 1-decanethiol and 1-octanethiol.

4. The wafer cleaning method according to any one of claims 1 to 3, wherein the sulfonic acid is at least one selected from the group consisting of sulfonic acids represented by the following general formula [4]
R⁵-S(=O)₂OH [4]
where R⁵ is a group selected from the group consisting of monovalent C₁-C₈ hydrocarbon groups in which a part or all of hydrogen atoms may be substituted with a fluorine atom.

5. The wafer cleaning method according to any one of claims 1 to 3, wherein the anhydride of the sulfonic acid is at least one selected from the group consisting of anhydrides of sulfonic acids represented by the following general formula [4]
R⁵-S(=O)₂OH [4]
where R⁵ is a group selected from the group consisting of monovalent C₁-C₈ hydrocarbon groups in which a part or all of hydrogen atoms may be substituted with a fluorine atom.

6. The wafer cleaning method according to any one of claims 1 to 3, wherein the salt of the sulfonic acid is at least one selected from the group consisting of ammonium salts and alkylamine salts of sulfonic acids represented by the following general formula [4]
R⁵-S(=O)₂OH [4]
where R⁵ is a group selected from the group consisting of monovalent C₁-C₈ hydrocarbon groups in which a part or all of hydrogen atoms may be substituted with a fluorine atom.

7. The wafer cleaning method according to any one of claims 1 to 3, wherein the sulfonic acid derivative is at least one selected from the group consisting of sulfonic acid derivatives represented by the following general formula [5]
R⁶-S(=O)₂O-Si(CH₃)₂(R⁷) [5]
where R⁶ is a monovalent C₁-C₈ hydrocarbon group in which a part or all of hydrogen atoms may be substituted with a fluorine atom; and R⁷ is a monovalent C₁-C₁₈ hydrocarbon group in which a part or all of hydrogen atoms may be substituted with a fluorine atom.

8. The wafer cleaning method according to any one of claims 1 to 7, wherein the alkoxysilane is at least one selected from the group consisting of alkoxysilanes represented by the following general formula [7]
(R¹⁰)*_{d}*Si(OR¹¹)_{4-*d*} [7]
where R¹⁰ is each independently a monovalent C₁-C₁₈ hydrocarbon group in which a part or all of hydrogen atoms may be substituted with a fluorine atom; R¹¹ is each independently a monovalent C₁-C₁₂ hydrocarbon group; and *d* is 2 or 3.

9. The wafer cleaning method according to any one of claims 1 to 8, wherein the alkoxysilane is at least one selected from the group consisting of monoalkoxysilanes represented by the following general formula [8]
(R¹⁰)-Si(CH₃)₂(OR¹¹) [8]
where R¹⁰ is a monovalent C₁-C₁₈ hydrocarbon group in which a part or all of hydrogen atoms may be substituted with a fluorine atom; and R¹¹ is a monovalent C₁-C₁₂ hydrocarbon group.

10. The wafer cleaning method according to any one of claims 1 to 9, wherein a concentration of the alkoxysilane in the water-repellent protective film-forming liquid chemical is 0.5 to 35 mass%.

11. The wafer cleaning method according to any one of claims 1 to 10, wherein a total concentration of the sulfonic acid, the anhydride of the sulfonic acid, the salt of the sulfonic acid and the sulfonic acid derivative in the water-repellent protective film-forming liquid chemical is 0.0001 to 5 mass%.

12. The wafer cleaning method according to any one of claims 1 to 11, further comprising, after retaining the water-repellent protective film-forming liquid chemical at least in the recess portion of the uneven pattern and thereby forming the water-repellent protective film on the surface of the recess portion, removing the water-repellent protective film-forming liquid chemical from the recess portion by drying.

13. The wafer cleaning method according to any one of claims 1 to 11, further comprising, after retaining the water-repellent protective film-forming liquid chemical at least in the recess portion of the uneven pattern and thereby forming the water-repellent protective film on the surface of the recess portion, replacing the water-repellent protective film-forming liquid chemical in the recess portion with a cleaning liquid, which is different from the water-repellent protective film-forming liquid chemical, and then removing the cleaning liquid from the recess portion by drying.

14. The wafer cleaning method according to claim 12 or 13, further comprising, after the drying, performing at least one treatment selected from the group consisting of heating treatment, light irradiation treatment, ozone exposure treatment, plasma irradiation treatment and corona discharge treatment on the surface of the wafer so as to thereby remove the water-repellent protective film.

15. The wafer cleaning method according to any one of claims 1 to 14, preparing the water-repellent protective film-forming liquid chemical by mixing a water-repellent protective film-forming liquid chemical kit,
the water-repellent protective film-forming liquid chemical kit comprising at least first and second liquids,
the first liquid including the alkoxysilane represented by the above general formula [1], or including the alkoxysilane represented by the above general formula [1] and the diluent solvent,
the second liquid including the at least one kind selected from the group consisting of the sulfonic acid represented by the above general formula [2], the anhydride of the sulfonic acid, the salt of the sulfonic acid and the sulfonic acid derivative represented by the above general formula [3], or including the at least one kind selected from the group consisting of the sulfonic acid represented by the above general formula [2], the anhydride of the sulfonic acid, the salt of the sulfonic acid and the sulfonic acid derivative represented by the above general formula [3] and the diluent solvent,
at least one of the first and second liquids containing the diluent solvent.

16. A water-repellent protective film-forming liquid chemical for use in a process of cleaning a wafer by means of a wafer cleaning machine, the wafer having on a surface thereof a fine uneven pattern at least partially containing a silicon element, the wafer cleaning machine having a liquid contact part containing a vinyl chloride resin, the water-repellent protective film-forming liquid chemical comprising:
an alkoxysilane represented by the following general formula [1];
at least one kind selected from the group consisting of a sulfonic acid represented by the following general formula [2], an anhydride of the sulfonic acid, a salt of the sulfonic acid and a sulfonic acid derivative represented by the following general formula [3]; and
a diluent solvent,
(R¹)*ₐ*Si(H)*_{b}*(OR²)_{4-*a*-*b*} [1]
where R¹ is each independently at least one group selected from the group consisting of monovalent C₁-C₁₈ hydrocarbon groups in which a part or all of hydrogen atoms may be substituted with a fluorine atom; R² is each independently a monovalent C₁-C₁₈ hydrocarbon group in which a part or all of hydrogen atoms may be substituted with a fluorine atom; *a* is an integer of 1 to 3; *b* is an integer of 0 to 2; and a sum of *a* and *b* is 3 or smaller,
R³-S(=O)₂OH [2]
where R³ is a group selected from the group consisting of monovalent C₁-C₈ hydrocarbon groups in which a part or all of hydrogen atoms may be substituted with a fluorine atom, and hydroxyl group,
R³-S(=O)₂O-Si(H)_{3-*c*}(R⁴)*_{c}* [3]
where R³ is a monovalent C₁-C₈ hydrocarbon group in which a part or all of hydrogen atoms may be substituted with a fluorine atom; R⁴ is each independently at least one group selected from the group consisting of monovalent C₁-C₁₈ hydrocarbon groups in which a part or all of hydrogen atoms may be substituted with a fluorine atom; and c is an integer of 1 to 3,
**characterized in that**:
the diluent solvent contains, based on 100 mass% of the entire diluent solvent, 80 to 100 mass% of at least one kind selected from the group consisting of hexane, heptane, octane, nonane, decane, dodecane, tetradecane, hexadecane, octadecane, eicosane, cyclohexane, methylcyclohexane, decalin, benzene, toluene, xylene, diethylbenzene, dipropyl ether, ethyl butyl ether, dibutyl ether, ethyl amyl ether, diamyl ether, methyl cyclopentyl ether, ethyl hexyl ether, dihexyl ether, dioctyl ether, diphenyl ether, methyl perfluoropropyl ether, ethyl perfluorobutyl ether, methyl perfluorohexyl ether, ethyl perfluorohexyl ether, 1-hexanethiol, 2-hexanethiol, 3-hexanethiol, 2-methyl-1-pentanethiol, 3-methyl-1-pentanethiol, 4-methyl-1-pentanethiol, 2-methyl-2-pentanethiol, 3-methyl-2-pentanethiol, 4-methy1-2-pentanethiol, 2-methy1-3-pentanethio1, 3-methyl-3-pentanethiol, 2,2-dimethyl-1-butanethiol, 3,3-dimethyl-1-butanethiol, 3,3-dimethyl-2-butanethiol, 2-ethyl-1-butanethiol, 1-heptanethiol, 2-heptanethiol, 3-heptanethiol, 4-heptanethiol, benzylthiol, 1-octanethiol, 2-octanethiol, 3-octanethiol, 4-octanethiol, 2-ethyl-1-hexanethiol, 1-nonanethiol, 2-nonanethiol, 3-nonanethiol, 4-nonanethiol, 5-nonanethiol, 1-decanethiol, 2-decanethiol, 3-decanethiol, 4-decanethiol, 5-decanethiol, tert-decanethiol, 1-undecanethiol, 2-undecanethiol, 3-undecanethiol, 4-undecanethiol, 5-undecanethiol, 6-undecanethiol, 1-dodecanethiol, 2-dodecanethiol, 3-dodecanethiol, 4-dodecanethiol, 5-dodecanethiol, 6-dodecanethiol, tert-dodecanethiol, 1-tridecanethiol, 2-tridecanethiol, 3-tridecanethiol, 4-tridecanethiol, 5-tridecanethiol, 6-tridecanethiol and 7-tridecanethiol, wherein hexane, heptane, octane, nonane, decane, dodecane, tetradecane, hexadecane, octadecane and eicosane may be in the linear form or in the branched form and the ethers may be in the linear form or in the branched form.

17. The water-repellent protective film-forming liquid chemical according to claim 16, wherein the diluent solvent contains, based on 100 mass% of the entire diluent solvent, 80 to 100 mass% of at least one kind selected from the group consisting of octane, nonane, decane, dodecane, cyclohexane, methylcyclohexane, decalin, ethyl t-butyl ether, methyl cyclopentyl ether, methyl perfluoropropyl ether, ethyl perfluorobutyl ether, methyl perfluorohexyl ether, ethyl perfluorohexyl ether, dibutyl ether, diamyl ether, dihexyl ether, dioctyl ether, 1-hexanethiol, 2-methyl-1-pentanethiol, 3-methyl-1-pentanethiol, 4-methyl-1-pentanethiol, 2,2-dimethyl-1-butanethiol, 3,3-dimethyl-1-butanethiol, 2-ethyl-1-butanethiol, 1-heptanethiol, benzylthiol, 1-octanethiol, 2-ethyl-1-hexanethiol, 1-nonanethiol, 1-decanethiol, 1-undecanethiol, 1-dodecanethiol and 1-tridecanethiol.

18. The water-repellent protective film-forming liquid chemical according to claim 17, wherein the diluent solvent contains, based on 100 mass% of the entire diluent solvent, 80 to 100 mass% of at least one kind selected from the group consisting of diamyl ether, dihexyl ether, decane, dodecane, decalin, 1 -dodecanethiol, 1-decanethiol and 1-octanethiol.

19. The water-repellent protective film-forming liquid chemical according to any one of claims 16 to 18, wherein the sulfonic acid is at least one selected from the group consisting of sulfonic acids represented by the following general formula [4]
R⁵-S(=O)₂OH [4]
where R⁵ is a group selected from the group consisting of monovalent C₁-C₈ hydrocarbon groups in which a part or all of hydrogen atoms may be substituted with a fluorine atom.

20. The water-repellent protective film-forming liquid chemical according to any one of claims 16 to 18, wherein the anhydride of the sulfonic acid is at least one selected from the group consisting of anhydrides of sulfonic acids represented by the following general formula [4]
R⁵-S(=O)₂OH [4]
where R⁵ is a group selected from the group consisting of monovalent C₁-C₈ hydrocarbon groups in which a part or all of hydrogen atoms may be substituted with a fluorine atom.

21. The water-repellent protective film-forming liquid chemical according to any one of claims 16 to 18, wherein the salt of the sulfonic acid is at least one selected from the group consisting of ammonium salts and alkylamine salts of sulfonic acids represented by the following general formula [4]
R⁵-S(=O)₂OH [4]
where R⁵ is a group selected from the group consisting of monovalent C₁-C₈ hydrocarbon groups in which a part or all of hydrogen atoms may be substituted with a fluorine atom.

22. The water-repellent protective film-forming liquid chemical according to any one of claims 16 to 18, wherein the sulfonic acid derivative is at least one selected from the group consisting of sulfonic acid derivatives represented by the following general formula [5]
R⁶-S(=O)₂O-Si(CH₃)₂(R⁷) [5]
where R⁶ is a monovalent C₁-C₈ hydrocarbon group in which a part or all of hydrogen atoms may be substituted with a fluorine atom; and R⁷ is a monovalent C₁-C₁₈ hydrocarbon group in which a part or all of hydrogen atoms may be substituted with a fluorine atom.

23. The water-repellent protective film-forming liquid chemical according to any one of claims 16 to 22, wherein the alkoxysilane is at least one selected from the group consisting of alkoxysilanes represented by the following general formula [7]
(R¹⁰)*_{d}*Si(OR¹¹)_{4-*d*} [7]
where R¹⁰ is each independently a monovalent C₁-C₁₈ hydrocarbon group in which a part or all of hydrogen atoms may be substituted with a fluorine atom; R¹¹ is each independently a monovalent C₁-C₁₂ hydrocarbon group; and *d* is 2 or 3.

24. The water-repellent protective film-forming liquid chemical according to any one of claims 16 to 23, wherein the alkoxysilane is at least one selected from the group consisting of monoalkoxysilanes represented by the following general formula [8]
(R¹⁰)-Si(CH₃)₂(OR¹¹) [8]
where R¹⁰ is a monovalent C₁-C₁₈ hydrocarbon group in which a part or all of hydrogen atoms may be substituted with a fluorine atom; and R¹¹ is a monovalent C₁-C₁₂ hydrocarbon group.

25. The water-repellent protective film-forming liquid chemical according to any one of claims 16 to 24, wherein a concentration of the alkoxysilane in the water-repellent protective film-forming liquid chemical is 0.5 to 35 mass%.

26. The water-repellent protective film-forming liquid chemical according to any one of claims 16 to 25, wherein a total concentration of the sulfonic acid, the anhydride of the sulfonic acid, the salt of the sulfonic acid and the sulfonic acid derivative in the water-repellent protective film-forming liquid chemical is 0.0001 to 5 mass%.

27. A water-repellent protective film-forming liquid chemical kit to be mixed for preparing the water-repellent protective film-forming liquid chemical according to any one of claims 16 to 26, comprising at least first and second liquids,
the first liquid containing the alkoxysilane represented by the above general formula [1], or containing the alkoxysilane represented by the above general formula [1] and the diluent solvent,
the second liquid containing the at least one kind selected from the group consisting of the sulfonic acid represented by the above general formula [2], the anhydride of the sulfonic acid, the salt of the sulfonic acid and the sulfonic acid derivative represented by the above general formula [3], or containing the at least one kind selected from the group consisting of the sulfonic acid represented by the above general formula [2], the anhydride of the sulfonic acid, the salt of the sulfonic acid and the sulfonic acid derivative represented by the above general formula [3] and the diluent solvent,
at least one of the first and second liquids containing the diluent solvent.

## Patentansprüche

1. Wafer-Reinigungs-Verfahren zur Reinigung eines Wafers mittels eines Wafer-Reinigungs-Geräts, wobei der Wafer auf einer Oberfläche seiner selbst ein feines, unebenes Muster aufweist, das zumindest teilweise ein Siliciumelement enthält, wobei das Wafer-Reinigungs-Gerät ein Flüssigkeitskontakt-Teil aufweist, welches ein Vinylchloridharz enthält,
wobei das Verfahren umfasst, dass zumindest in einem Vertiefungsbereich des unebenen Musters eine einen wasserabweisenden Schutzfilm bildende flüssige Chemikalie zurückgehalten wird, wodurch auf einer Oberfläche des Vertiefungsbereichs ein wasserabweisender Schutzfilm gebildet wird,
wobei die einen wasserabweisenden Schutzfilm bildende flüssige Chemikalie umfasst:
ein durch die folgende allgemeine Formel [1] dargestelltes Alkoxysilan;
zumindest eine Art, die ausgewählt ist aus der Gruppe bestehend aus einer durch die folgende allgemeine Formel [2] dargestellten Sulfonsäure, einem Anhydrid der Sulfonsäure, einem Salz der Sulfonsäure und einem durch die folgende allgemeine Formel [3] dargestellten Sulfonsäurederivat; und
ein Verdünner-Lösungsmittel,
(R¹)*a*Si(H)*_{b}*(OR²)_{4-*a*-*b*} [1],
worin jedes R¹ unabhängig voneinander mindestens eine Gruppe ist, welche ausgewählt ist aus der Gruppe bestehend aus einwertigen C₁-C₁₈-Kohlenwasserstoffgruppen, in denen ein Teil oder alle der Wasserstoffatome durch ein Fluoratom ersetzt sein können; jedes R² unabhängig voneinander eine einwertige C₁-C₁₈-Kohlenwasserstoffgruppe ist, in der ein Teil oder alle der Wasserstoffatome durch ein Fluoratom ersetzt sein können; a eine ganze Zahl von 1 bis 3 ist; *b* eine ganze Zahl von 0 bis 2 ist; und eine Summe von a und b 3 oder kleiner ist,
R³-S(=O)₂OH [2],
worin R³ eine Gruppe ist, welche ausgewählt ist aus der Gruppe, die aus einwertigen C₁-C₁₈-Kohlenwasserstoffgruppen, in denen ein Teil oder alle der Wasserstoffatome durch ein Fluoratom ersetzt sein können, und einer Hydroxygruppe besteht,
R³-S(=O)₂O-Si(H)_{3-*c*}(R⁴)*_{c}* [3],
worin R³ eine einwertige C₁-C₈-Kohlenwasserstoffgruppe ist, in der ein Teil oder alle der Wasserstoffatome durch ein Fluoratom ersetzt sein können; jedes R⁴ unabhängig voneinander mindestens eine Gruppe ist, welche ausgewählt ist aus der Gruppe bestehend aus einwertigen C₁-C₁₈-Kohlenwasserstoffgruppen, in denen ein Teil oder alle der Wasserstoffatome durch ein Fluoratom ersetzt sein können; und c eine ganze Zahl von 1 bis 3 ist,
**dadurch gekennzeichnet, dass**:
das Verdünner-Lösungsmittel, bezogen auf 100 Massenprozent des gesamten Verdünner-Lösungsmittels, 80 bis 100 Massenprozent mindestens einer Art enthält, welche ausgewählt ist aus der Gruppe bestehend aus Hexan, Heptan, Octan, Nonan, Decan, Dodecan, Tetradecan, Hexadecan, Octadecan, Eicosan, Cyclohexan, Methylcyclohexan, Decalin, Benzol, Toluol, Xylol, Diethylbenzol, Dipropylether, Ethylbutylether, Dibutylether, Ethylamylether, Diamylether, Methylcyclopentylether, Ethylhexylether, Dihexylether, Dioctylether, Diphenylether, Methylperfluorpropylether, Ethylperfluorbutylether, Methylperfluorhexylether, Ethylperfluorhexylether, 1-Hexanthiol, 2-Hexanthiol, 3-Hexanthiol, 2-Methyl-1-pentanthiol, 3-Methyl-1-pentanthiol, 4-Methyl-1-pentanthiol, 2-Methyl-2-pentanthiol, 3-Methyl-2-pentanthiol, 4-Methyl-2-pentanthiol, 2-Methyl-3-pentanthiol, 3-Methyl-3-pentanthiol, 2,2-Dimethyl-1-butanthiol, 3,3-Dimethyl-1-butanthiol, 3,3-Dimethyl-2-butanthiol, 2-Ethyl-1-butanthiol, 1-Heptanthiol, 2-Heptanthiol, 3-Heptanthiol, 4-Heptanthiol, Benzylthiol, 1-Octanthiol, 2-Octanthiol, 3-Octanthiol, 4-Octanthiol, 2-Ethyl-1-hexanthiol, 1-Nonanthiol, 2-Nonanthiol, 3-Nonanthiol, 4-Nonanthiol, 5-Nonanthiol, 1-Decanthiol, 2-Decanthiol, 3-Decanethiol, 4-Decanthiol, 5-Decanthiol, tert-Decanthiol, 1-Undecanthiol, 2-Undecanthiol, 3-Undecanthiol, 4-Undecanthiol, 5-Undecanthiol, 6-Undecanthiol, 1-Dodecanthiol, 2-Dodecanthiol, 3-Dodecanthiol, 4-Dodecanthiol, 5-Dodecanthiol, 6-Dodecanthiol, tert-Dodecanthiol, 1-Tridecanthiol, 2-Tridecanthiol, 3-Tridecanthiol, 4-Tridecanthiol, 5-Tridecanthiol, 6-Tridecanthiol und 7-Tridecanthiol, wobei Hexan, Heptan, Octan, Nonan, Decan, Dodecan, Tetradecan, Hexadecan, Octadecan und Eicosan in der linearen Form oder in der verzweigten Form sein können und die Ether in der linearen Form oder in der verzweigten Form sein können.

2. Wafer-Reinigungs-Verfahren nach Anspruch 1, wobei das Verdünner-Lösungsmittel, bezogen auf 100 Massenprozent des gesamten Verdünner-Lösungsmittels, 80 bis 100 Massenprozent mindestens einer Art enthält, welche ausgewählt ist aus der Gruppe bestehend aus Octan, Nonan, Decan, Dodecan, Cyclohexan, Methylcyclohexan, Decalin, Ethyl-t-butylether, Methylcyclopentylether, Methylperfluorpropylether, Ethylperfluorbutylether, Methylperfluorhexylether, Ethylperfluorhexylether, Dibutylether, Diamylether, Dihexylether, Dioctylether, 1-Hexanthiol, 2-Methyl-1-pentanthiol, 3-Methyl-1-pentanthiol, 4-Methyl-1-pentanthiol, 2,2-Dimethyl-1-butanthiol, 3,3-Dimethyl-1-butanthiol, 2-Ethyl-1-butanthiol, 1-Heptanthiol, Benzylthiol, 1-Octanthiol, 2-Ethyl-1-hexanthiol, 1-Nonanthiol, 1-Decanthiol, 1-Undecanthiol, 1-Dodecanthiol und 1-Tridecanthiol.

3. Wafer-Reinigungs-Verfahren nach Anspruch 2, wobei das Verdünner-Lösungsmittel, bezogen auf 100 Massenprozent des gesamten Verdünner-Lösungsmittels, 80 bis 100 Massenprozent mindestens einer Art enthält, welche ausgewählt ist aus der Gruppe bestehend aus Diamylether, Dihexylether, Decan, Dodecan, Decalin, 1-Dodecanthiol, 1-Decanthiol und 1-Octanthiol.

4. Wafer-Reinigungs-Verfahren nach einem der Ansprüche 1 bis 3, wobei die Sulfonsäure mindestens eine ist, welche ausgewählt ist aus der Gruppe bestehend aus durch die folgende allgemeine Formel [4] dargestellten Sulfonsäuren
R⁵-S(=O)₂OH [4],
worin R⁵ eine Gruppe ist, welche ausgewählt ist aus der Gruppe bestehend aus einwertigen C₁-C₈-Kohlenwasserstoffgruppen, in denen ein Teil oder alle der Wasserstoffatome durch ein Fluoratom ersetzt sein können.

5. Wafer-Reinigungs-Verfahren nach einem der Ansprüche 1 bis 3, wobei das Anhydrid der Sulfonsäure mindestens eines ist, welches ausgewählt ist aus der Gruppe bestehend aus Anhydriden von durch die folgende allgemeine Formel [4] dargestellten Sulfonsäuren
R⁵-S(=O)₂OH [4],
worin R⁵ eine Gruppe ist, welche ausgewählt ist aus der Gruppe bestehend aus einwertigen C₁-C₈-Kohlenwasserstoffgruppen, in denen ein Teil oder alle der Wasserstoffatome durch ein Fluoratom ersetzt sein können.

6. Wafer-Reinigungs-Verfahren nach einem der Ansprüche 1 bis 3, wobei das Salz der Sulfonsäure mindestens eines ist, welches ausgewählt ist aus der Gruppe bestehend aus Ammoniumsalzen und Alkylaminsalzen von durch die folgende allgemeine Formel [4] dargestellten Sulfonsäuren
R⁵-S(=O)₂OH [4],
worin R⁵ eine Gruppe ist, welche ausgewählt ist aus der Gruppe bestehend aus einwertigen C₁-C₈-Kohlenwasserstoffgruppen, in denen ein Teil oder alle der Wasserstoffatome durch ein Fluoratom ersetzt sein können.

7. Wafer-Reinigungs-Verfahren nach einem der Ansprüche 1 bis 3, wobei das Sulfonsäurederivat mindestens eines ist, welche ausgewählt ist aus der Gruppe bestehend aus durch die folgende allgemeine Formel [5] dargestellten Sulfonsäurederivaten
R⁶-S(=O)₂O-Si(CH₃)₂(R⁷) [5],
worin R⁶ eine einwertige C₁-C₈-Kohlenwasserstoffgruppe ist, in der ein Teil oder alle der Wasserstoffatome durch ein Fluoratom ersetzt sein können; und R⁷ eine einwertige C₁-C₁₈-Kohlenwasserstoffgruppe ist, in der ein Teil oder alle der Wasserstoffatome durch ein Fluoratom ersetzt sein können.

8. Wafer-Reinigungs-Verfahren nach einem der Ansprüche 1 bis 7, wobei das Alkoxysilan mindestens eines ist, welches ausgewählt ist aus der Gruppe bestehend aus durch die folgende allgemeine Formel [7] dargestellten Alkoxysilanen
(R¹⁰)*_{d}*Si(OR¹¹)_{4-*d*} [7],
worin jedes R¹⁰ unabhängig voneinander eine einwertige C₁-C₁₈-Kohlenwasserstoffgruppe ist, in der ein Teil oder alle der Wasserstoffatome durch ein Fluoratom ersetzt sein können; jedes R¹¹ unabhängig voneinander eine einwertige C₁-C₁₂-Kohlenwasserstoffgruppe ist; und *d* 2 oder 3 ist.

9. Wafer-Reinigungs-Verfahren nach einem der Ansprüche 1 bis 8, wobei das Alkoxysilan mindestens eines ist, welches ausgewählt ist aus der Gruppe bestehend aus durch die folgende allgemeine Formel [8] dargestellten Monoalkoxysilanen
(R¹⁰)-Si(CH₃)₂(OR¹¹) [8],
worin R¹⁰ eine einwertige C₁-C₁₈-Kohlenwasserstoffgruppe ist, in der ein Teil oder alle der Wasserstoffatome durch ein Fluoratom ersetzt sein können; und R¹¹ eine einwertige C₁-C₁₂-Kohlenwasserstoffgruppe ist.

10. Wafer-Reinigungs-Verfahren nach einem der Ansprüche 1 bis 9, wobei eine Konzentration des Alkoxysilans in der einen wasserabweisenden Schutzfilm bildenden flüssigen Chemikalie 0.5 bis 35 Massenprozent beträgt.

11. Wafer-Reinigungs-Verfahren nach einem der Ansprüche 1 bis 10, wobei eine Gesamtkonzentration der Sulfonsäure, des Anhydrids der Sulfonsäure, des Salzes der Sulfonsäure und des Sulfonsäurederivats in der einen wasserabweisenden Schutzfilm bildenden flüssigen Chemikalie 0,0001 bis 5 Massenprozent beträgt.

12. Wafer-Reinigungs-Verfahren nach einem der Ansprüche 1 bis 11, welches zudem umfasst, dass, nach dem Zurückhalten der einen wasserabweisenden Schutzfilm bildenden flüssigen Chemikalie zumindest in dem Vertiefungsbereich des unebenen Musters und dem dadurch erfolgenden Bilden des wasserabweisenden Schutzfilms auf der Oberfläche des Vertiefungsbereichs, die einen wasserabweisenden Schutzfilm bildende flüssige Chemikalie durch Trocknung aus dem Vertiefungsbereich entfernt wird.

13. Wafer-Reinigungs-Verfahren nach einem der Ansprüche 1 bis 11, welches zudem umfasst, dass, nach dem Zurückhalten der einen wasserabweisenden Schutzfilm bildenden flüssigen Chemikalie zumindest in dem Vertiefungsbereich des unebenen Musters und dem dadurch erfolgenden Bilden des wasserabweisenden Schutzfilms auf der Oberfläche des Vertiefungsbereichs, die einen wasserabweisenden Schutzfilm bildende flüssige Chemikalie in dem Vertiefungsbereich gegen eine Reinigungsflüssigkeit ausgetauscht wird, welche von der einen wasserabweisenden Schutzfilm bildenden flüssigen Chemikalie verschieden ist, und daraufhin die Reinigungsflüssigkeit durch Trocknung aus dem Vertiefungsbereich entfernt wird.

14. Wafer-Reinigungs-Verfahren nach Anspruch 12 oder 13, welches zudem umfasst, dass, nach dem Trocknen, an der Oberfläche des Wafers mindestens eine Behandlung durchgeführt wird, welche ausgewählt ist aus der Gruppe bestehend aus Wärme-Behandlung, Licht-Bestrahlungs-Behandlung, Ozon-Einwirkungs-Behandlung, Plasma-Bestrahlungs-Behandlung und Korona-Entladungs-Behandlung, um dadurch den wasserabweisenden Schutzfilm zu entfernen.

15. Wafer-Reinigungs-Verfahren nach einem der Ansprüche 1 bis 14, wobei die einen wasserabweisenden Schutzfilm bildende flüssige Chemikalie hergestellt wird, indem ein Kit für eine einen wasserabweisenden Schutzfilm bildende flüssige Chemikalie vermischt wird,
wobei das Kit für eine einen wasserabweisenden Schutzfilm bildende flüssige Chemikalie mindestens erste und zweite Flüssigkeiten umfasst,
wobei die erste Flüssigkeit das durch die obige allgemeine Formel [1] dargestellte Alkoxysilan umfasst, oder das durch die obige allgemeine Formel [1] dargestellte Alkoxysilan und das Verdünner-Lösungsmittel umfasst,
wobei die zweite Flüssigkeit die mindestens eine Art, welche ausgewählt ist aus der Gruppe bestehend aus der durch die obige allgemeine Formel [2] dargestellten Sulfonsäure, dem Anhydrid der Sulfonsäure, dem Salz der Sulfonsäure und dem durch die obige allgemeine Formel [3] dargestellten Sulfonsäurederivat umfasst, oder die mindestens eine Art, welche ausgewählt ist aus der Gruppe bestehend aus der durch die obige allgemeine Formel [2] dargestellten Sulfonsäure, dem Anhydrid der Sulfonsäure, dem Salz der Sulfonsäure und dem durch die obige allgemeine Formel [3] dargestellten Sulfonsäurederivat, und das Verdünner-Lösungsmittel umfasst,
wobei mindestens eine der ersten und zweiten Flüssigkeiten das Verdünner-Lösungsmittel enthält.

16. Einen wasserabweisenden Schutzfilm bildende flüssige Chemikalie zur Verwendung in einem Verfahren zur Reinigung eines Wafers mittels eines Wafer-Reinigungs-Geräts, wobei der Wafer auf einer Oberfläche seiner selbst ein feines, unebenes Muster aufweist, das zumindest teilweise ein Siliciumelement enthält, wobei das Wafer-Reinigungs-Gerät ein Flüssigkeitskontakt-Teil aufweist, welches ein Vinylchloridharz enthält, wobei die einen wasserabweisenden Schutzfilm bildende Chemikalie umfasst:
ein durch die folgende allgemeine Formel [1] dargestelltes Alkoxysilan;
mindestens eine Art, welche ausgewählt ist aus der Gruppe bestehend aus einer durch die folgende allgemeine Formel [2] dargestellten Sulfonsäure, einem Anhydrid der Sulfonsäure, einem Salz der Sulfonsäure und einem durch die folgende allgemeine Formel [3] dargestellten Sulfonsäurederivat; und
ein Verdünner-Lösungsmittel,
(R¹)*ₐ*Si(H)*_{b}*(OR²)_{4-*a*-*b*} [1],
worin jedes R¹ unabhängig voneinander mindestens eine Gruppe ist, welche ausgewählt ist aus der Gruppe bestehend aus einwertigen C₁-C₁₈-Kohlenwasserstoffgruppen, in denen ein Teil oder alle der Wasserstoffatome durch Fluoratome ersetzt sein können; jedes R² unabhängig voneinander eine einwertige C₁-C₁₈-Kohlenwasserstoffgruppe ist, in der ein Teil oder alle der Wasserstoffatome durch ein Fluoratom ersetzt sein können; a eine ganze Zahl von 1 bis 3 ist; b eine ganze Zahl von 0 bis 2 ist; und eine Summe von a und b 3 oder kleiner ist,
R³-S(=O)₂OH [2],
worin R³ ein Gruppe ist, welche ausgewählt ist aus der Gruppe, die aus einwertigen C₁-C₁₈-Kohlenwasserstoffgruppen, in denen ein Teil oder alle der Wasserstoffatome durch ein Fluoratom ersetzt sein können, und einer Hydroxygruppe besteht,
R³-S(=O)₂O-Si(H)_{3-*c*}(R⁴)*_{c}* [3],
worin R³ eine einwertige C₁-C₈-Kohlenwasserstoffgruppe ist, in der ein Teil oder alle der Wasserstoffatome durch ein Fluoratom ersetzt sein können; jedes R⁴ unabhängig voneinander mindestens eine Gruppe ist, welche ausgewählt ist aus der Gruppe bestehend aus einwertigen C₁-C₁₈-Kohlenwasserstoffgruppen, in denen ein Teil oder alle der Wasserstoffatome durch ein Fluoratom ersetzt sein können; und c eine ganze Zahl von 1 bis 3 ist,
**dadurch gekennzeichnet, dass**:
das Verdünner-Lösungsmittel, bezogen auf 100 Massenprozent des gesamten Verdünner-Lösungsmittels, 80 bis 100 Massenprozent mindestens einer Art enthält, welche ausgewählt ist aus der Gruppe bestehend aus Hexan, Heptan, Octan, Nonan, Decan, Dodecan, Tetradecan, Hexadecan, Octadecan, Eicosan, Cyclohexan, Methylcyclohexan, Decalin, Benzol, Toluol, Xylol, Diethylbenzol, Dipropylether, Ethylbutylether, Dibutylether, Ethylamylether, Diamylether, Methylcyclopentylether, Ethylhexylether, Dihexylether, Dioctylether, Diphenylether, Methylperfluorpropylether, Ethylperfluorbutylether, Methylperfluorhexylether, Ethylperfluorhexylether, 1-Hexanthiol, 2-Hexanthiol, 3-Hexanthiol, 2-Methyl-1-pentanthiol, 3-Methyl-1-pentanthiol, 4-Methyl-1-pentanthiol, 2-Methyl-2-pentanthiol, 3-Methyl-2-pentanthiol, 4-Methyl-2-pentanthiol, 2-Methyl-3-pentanthiol, 3-Methyl-3-pentanthiol, 2,2-Dimethyl-1-butanthiol, 3,3-Dimethyl-1-butanthiol, 3,3-Dimethyl-2-butanthiol, 2-Ethyl-1-butanthiol, 1-Heptanthiol, 2-Heptanthiol, 3-Heptanthiol, 4-Heptanthiol, Benzylthiol, 1-Octanthiol, 2-Octanthiol, 3-Octanthiol, 4-Octanthiol, 2-Ethyl-1-hexanthiol, 1-Nonanthiol, 2-Nonanthiol, 3-Nonanthiol, 4-Nonanthiol, 5-Nonanthiol, 1-Decanthiol, 2-Decanthiol, 3-Decanethiol, 4-Decanthiol, 5-Decanthiol, tert-Decanthiol, 1-Undecanthiol, 2-Undecanthiol, 3-Undecanthiol, 4-Undecanthiol, 5-Undecanthiol, 6-Undecanthiol, 1-Dodecanthiol, 2-Dodecanthiol, 3-Dodecanthiol, 4-Dodecanthiol, 5-Dodecanthiol, 6-Dodecanthiol, tert-Dodecanthiol, 1-Tridecanthiol, 2-Tridecanthiol, 3-Tridecanthiol, 4-Tridecanthiol, 5-Tridecanthiol, 6-Tridecanthiol und 7-Tridecanthiol, wobei Hexan, Heptan, Octan, Nonan, Decan, Dodecan, Tetradecan, Hexadecan, Octadecan und Eicosan in der linearen Form oder in der verzweigten Form sein können und die Ether in der linearen Form oder in der verzweigten Form sein können.

17. Einen wasserabweisenden Schutzfilm bildende flüssige Chemikalie nach Anspruch 16, wobei das Verdünner-Lösungsmittel, bezogen auf 100 Massenprozent des gesamten Verdünner-Lösungsmittels, 80 bis 100 Massenprozent mindestens einer Art enthält, welche ausgewählt ist aus der Gruppe bestehend aus Octan, Nonan, Decan, Dodecan, Cyclohexan, Methylcyclohexan, Decalin, Ethyl-t-butylether, Methylcyclopentylether, Methylperfluorpropylether, Ethylperfluorbutylether, Methylperfluorhexylether, Ethylperfluorhexylether, Dibutylether, Diamylether, Dihexylether, Dioctylether, 1-Hexanthiol, 2-Methyl-1-pentanthiol, 3-Methyl-1-pentanthiol, 4-Methyl-1-pentanthiol, 2,2-Dimethyl-1-butanthiol, 3,3-Dimethyl-1-butanthiol, 2-Ethyl-1-butanthiol, 1-Heptanthiol, Benzylthiol, 1-Octanthiol, 2-Ethyl-1-hexanthiol, 1-Nonanthiol, 1-Decanthiol, 1-Undecanthiol, 1-Dodecanthiol und 1-Tridecanthiol.

18. Einen wasserabweisenden Schutzfilm bildende flüssige Chemikalie nach Anspruch 17, wobei das Verdünner-Lösungsmittel, bezogen auf 100 Massenprozent des gesamten Verdünner-Lösungsmittels, 80 bis 100 Massenprozent mindestens einer Art enthält, welche ausgewählt ist aus der Gruppe bestehend aus Diamylether, Dihexylether, Decan, Dodecan, Decalin, 1-Dodecanthiol, 1-Decanthiol und 1-Octanthiol.

19. Einen wasserabweisenden Schutzfilm bildende flüssige Chemikalie nach einem der Ansprüche 16 bis 18, wobei die Sulfonsäure mindestens eine ist, welche ausgewählt ist aus der Gruppe bestehend aus durch die folgende allgemeine Formel [4] dargestellten Sulfonsäuren
R⁵-S(=O)₂OH [4],
worin R⁵ eine Gruppe ist, welche ausgewählt ist aus der Gruppe bestehend aus einwertigen C₁-C₈-Kohlenwasserstoffgruppen, in denen ein Teil oder alle der Wasserstoffatome durch ein Fluoratom ersetzt sein können.

20. Einen wasserabweisenden Schutzfilm bildende flüssige Chemikalie nach einem der Ansprüche 16 bis 18, wobei das Anhydrid der Sulfonsäure mindestens eines ist, welches ausgewählt ist aus der Gruppe bestehend aus Anhydriden von durch die folgende allgemeine Formel [4] dargestellten Sulfonsäuren
R⁵-S(=O)₂OH [4],
worin R⁵ eine Gruppe ist, welche ausgewählt ist aus der Gruppe bestehend aus einwertigen C₁-C₈-Kohlenwasserstoffgruppen, in denen ein Teil oder alle der Wasserstoffatome durch ein Fluoratom ersetzt sein können.

21. Einen wasserabweisenden Schutzfilm bildende flüssige Chemikalie nach einem der Ansprüche 16 bis 18, wobei das Salz der Sulfonsäure mindestens eines ist, welches ausgewählt ist aus der Gruppe bestehend aus Ammoniumsalzen und Alkylaminsalzen von durch die folgende allgemeine Formel [4] dargestellten Sulfonsäuren
R⁵-S(=O)₂OH [4],
worin R⁵ eine Gruppe ist, welche ausgewählt ist aus der Gruppe bestehend aus einwertigen C₁-C₈-Kohlenwasserstoffgruppen, in denen ein Teil oder alle der Wasserstoffatome durch ein Fluoratom ersetzt sein können.

22. Einen wasserabweisenden Schutzfilm bildende flüssige Chemikalie nach einem der Ansprüche 16 bis 18, wobei das Sulfonsäurederivat mindestens eines ist, welches ausgewählt ist aus der Gruppe bestehend aus durch die folgende allgemeine Formel [5] dargestellten Sulfonsäurederivaten
R⁶-S(=O)₂O-Si(CH₃)₂(R⁷) [5],
worin R⁶ eine einwertige C₁-C₈-Kohlenwasserstoffgruppe ist, in der ein Teil oder alle der Wasserstoffatome durch ein Fluoratom ersetzt sein können; und R⁷ eine einwertige C₁-C₁₈-Kohlenwasserstoffgruppe ist, in der ein Teil oder alle der Wasserstoffatome durch ein Fluoratom ersetzt sein können.

23. Einen wasserabweisenden Schutzfilm bildende flüssige Chemikalie nach einem der Ansprüche 16 bis 22, wobei das Alkoxysilan mindestens eines ist, welches ausgewählt ist aus der Gruppe bestehend aus durch die folgende allgemeine Formel [7] dargestellten Alkoxysilanen
(R¹⁰)*_{d}*Si(OR¹¹)_{4-*d*} [7],
worin jedes R¹⁰ unabhängig voneinander eine einwertige C₁-C₁₈-Kohlenwasserstoffgruppe ist, in der ein Teil oder alle der Wasserstoffatome durch ein Fluoratom ersetzt sein können; jedes R¹¹ unabhängig voneinander eine einwertige C₁-C₁₂-Kohlenwasserstoffgruppe ist; und *d* 2 oder 3 ist.

24. Einen wasserabweisenden Schutzfilm bildende flüssige Chemikalie nach einem der Ansprüche 16 bis 23, wobei das Alkoxysilan mindestens eines ist, welches ausgewählt ist aus der Gruppe bestehend aus durch die folgende allgemeine Formel [8] dargestellten Monoalkoxysilanen
(R¹⁰)-Si(CH₃)₂(OR¹¹) [8],
worin R¹⁰ eine einwertige C₁-C₁₈-Kohlenwasserstoffgruppe ist, in der ein Teil oder alle der Wasserstoffatome durch ein Fluoratom ersetzt sein können; und R¹¹ eine einwertige C₁-C₁₂-Kohlenwasserstoffgruppe ist.

25. Einen wasserabweisenden Schutzfilm bildende flüssige Chemikalie nach einem der Ansprüche 16 bis 24, wobei eine Konzentration des Alkoxysilans in der einen wasserabweisenden Schutzfilm bildenden flüssigen Chemikalie 0,5 bis 35 Massenprozent beträgt.

26. Einen wasserabweisenden Schutzfilm bildende flüssige Chemikalie nach einem der Ansprüche 16 bis 25, wobei eine Gesamtkonzentration der Sulfonsäure, des Anhydrids der Sulfonsäure, des Salzes der Sulfonsäure und des Sulfonsäurederivats in der einen wasserabweisenden Schutzfilm bildenden flüssigen Chemikalie 0,0001 bis 5 Massenprozent beträgt.

27. Kit für eine einen wasserabweisenden Schutzfilm bildende flüssige Chemikalie zum Vermischen für die Herstellung der einen wasserabweisenden Schutzfilm bildenden flüssigen Chemikalie nach einem der Ansprüche 16 bis 26, welches mindestens erste und zweite Flüssigkeiten umfasst,
wobei die erste Flüssigkeit das durch die obige allgemeine Formel [1] dargestellte Alkoxysilan enthält, oder das durch die obige allgemeine Formel [1] dargestellte Alkoxysilan und das Verdünner-Lösungsmittel enthält,
wobei die zweite Flüssigkeit die mindestens eine Art, welche ausgewählt ist aus der Gruppe bestehend aus der durch die obige allgemeine Formel [2] dargestellten Sulfonsäure, dem Anhydrid der Sulfonsäure, dem Salz der Sulfonsäure und dem durch die obige allgemeine Formel [3] dargestellten Sulfonsäurederivat, enthält, oder die mindestens eine Art, welche ausgewählt ist aus der Gruppe bestehend aus der durch die obige allgemeine Formel [2] dargestellten Sulfonsäure, dem Anhydrid der Sulfonsäure, dem Salz der Sulfonsäure und dem durch die obige allgemeine Formel [3] dargestellten Sulfonsäurederivat, und das Verdünner-Lösungsmittel enthält,
wobei mindestens eine der ersten und zweiten Flüssigkeiten das Verdünner-Lösungsmittel enthält.

## Revendications

1. Procédé de nettoyage d'une tranche permettant le nettoyage d'une tranche au moyen d'une machine de nettoyage de tranche, la tranche ayant sur une de ses surfaces un motif fin inégal contenant au moins partiellement l'élément silicium, la machine de nettoyage de tranches ayant une partie de contact liquide contenant une résine de chlorure de vinyle,
le procédé comprenant la retenue d'un produit chimique liquide filmogène protecteur hydrofuge au moins dans une partie en retrait du motif inégal, formant ainsi un film protecteur hydrofuge sur une surface de la partie en retrait,
le produit chimique liquide filmogène protecteur hydrofuge comprenant : un alcoxy silane représenté par la formule générale suivante [1] ; au moins un type de produit choisi dans le groupe constitué d'un acide sulfonique représenté par la formule générale suivante [2], d'un anhydride de l'acide sulfonique, d'un sel de l'acide sulfonique et d'un dérivé de l'acide sulfonique représenté par la formule générale suivante [3] ; et un solvant de dilution,
(R¹)*ₐ*Si(H)*_{b}*(OR²)_{4-*a*-*b*} [1]
où chaque R¹ est de manière indépendante au moins un groupement choisi dans le groupe constitué de groupements hydrocarbonés en C₁ à C₁₈ monovalents dans lesquels une partie des atomes d'hydrogène ou tous peuvent être substitués avec un atome de fluor ; chaque R² est de manière indépendante un groupement hydrocarboné en C₁ à C₁₈ monovalent dans lequel une partie des atomes d'hydrogène ou tous peuvent être substitués avec un atome de fluor ; a est un nombre entier de 1 à 3; *b* est un nombre entier de 0 à 2 ; et une somme de a et de b est inférieure ou égale à 3,
R³-S(=O)₂OH [2]
où R³ est un groupement choisi dans le groupe constitué de groupements hydrocarbonés en C₁ à C₈ monovalents dans lesquels une partie ou tous les atomes d'hydrogène peuvent être substitués avec un atome de fluor, et un groupement hydroxyle,
R³-S(=O)₂O-Si(H)_{3-*c*}(R⁴)*_{c}* [3]
où R³ est un groupement hydrocarboné en C₁ à C₈ monovalent dans lequel une partie ou tous les atomes d'hydrogène peuvent être substitués avec un atome de fluor ; chaque R⁴ est de manière indépendante au moins un groupement choisi dans le groupe constitué de groupements hydrocarbonés en C₁ à C₁₈ monovalents dans lesquels une partie ou tous les atomes d'hydrogène peuvent être substitués avec un atome de fluor ; et c est un nombre entier de 1 à 3,
**caractérisé en ce que** :
le solvant de dilution contient, sur une base de 100 % en masse du solvant de dilution entier, de 80 à 100 % en masse au moins un type de produit choisi dans le groupe constitué de l'hexane, de l'heptane, de l'octane, du nonane, du décane, du dodécane, du tétradécane, de l'hexadécane, de l'octadécane, de l'éicosane, du cyclohexane, du méthylcyclohexane, de la décaline, du benzène, du toluène, du xylène, du diéthylbenzène, du dipropyl éther, de l'éthyl butyl éther, du dibutyl éther, de l'éthyl amyl éther, du diamyl éther, du méthyl cyclopentyl éther, de l'éthyl hexyl éther, du dihexyl éther, du dioctyl éther, du diphényl éther, du méthyl perfluoropropyl éther, de l'éthyl perfluorobutyl éther, du méthyl perfluorohexyl éther, de l'éthyl perfluorohexyl éther, du 1-hexanethiol, du 2-hexanethiol, du 3-hexanethiol, du 2-méthyl-1-pentanethiol, du 3-méthyl-1-pentanethiol, du 4-méthyl-1 - pentanethiol, du 2-méthyl-2-pentanethiol, du 3-méthyl-2-pentanethiol, du 4-méthyl-2-pentanethiol, du 2-méthyl-3-pentanethiol, du 3-méthyl-3-pentanethiol, du 2,2-diméthyl-1 -butanethiol, du 3,3-diméthyl-1 -butanethiol, du 3,3-diméthyl-2-butanethiol, du 2-éthyl-1-butanethiol, du 1-heptanethiol, du 2-heptanethiol, du 3-heptanethiol, du 4-heptanethiol, du benzylthiol, du 1-octanethiol, du 2-octanethiol, du 3-octanethiol, du 4-octanethiol, du 2-éthyl-1-hexanethiol, du 1-nonanethiol, du 2-nonanethiol, du 3-nonanethiol, du 4-nonanethiol, du 5-nonanethiol, du 1-décanethiol, du 2-décanethiol, du 3-décanethiol, du 4-décanethiol, du 5-décanethiol, du tert-décanethiol, du 1-undécanethiol, du 2-undécanethiol, du 3-undécanethiol, du 4-undécanethiol, du 5-undécanethiol, du 6-undécanethiol, du 1-dodécanethiol, du 2-dodécanethiol, du 3-dodécanethiol, du 4-dodécanethiol, du 5-dodécanethiol, du 6-dodécanethiol, du tert-dodécanethiol, du 1-tridécanethiol, du 2-tridécanethiol, du 3-tridécanethiol, du 4-tridécanethiol, du 5-tridécanethiol, du 6-tridécanethiol et du 7-tridécanethiol, dans lequel l'hexane, l'heptane, l'octane, le nonane, le décane, le dodécane, le tétradécane, l'hexadécane, l'octadécane et l'éicosane peuvent être sous forme linéaire ou sous forme ramifiée et les éthers peuvent être sous forme linéaire ou sous forme ramifiée.

2. Procédé de nettoyage d'une tranche selon la revendication 1, dans lequel le solvant de dilution contient, sur la base de 100 % en masse du solvant de dilution entier, de 80 à 100 % en masse d'au moins un type de produit choisi dans le groupe constitué de l'octane, du nonane, du décane, du dodécane, du cyclohexane, du méthylcyclohexane, de la décaline, de l'éthyl t-butyl éther, du méthyl cyclopentyl éther, du méthyl perfluoropropyl éther, de l'éthyl perfluorobutyl éther, du méthyl perfluorohexyl éther, de l'éthyl perfluorohexyl éther, du dibutyl éther, du diamyl éther, du dihexyl éther, du dioctyl éther, de l'1-hexanethiol, du 2-méthyl-1-pentanethiol, du 3-méthyl-1-pentanethiol, du 4-méthyl-1-pentanethiol, du 2,2-diméthyl-1-butanethiol, du 3,3-diméthyl-1 -butanethiol, du 2-éthyl-1-butanethiol, du 1-heptanethiol, du benzylthiol, du 1-octanethiol, du 2-éthyl-1-hexanethiol, du 1-nonanethiol, du 1-décanethiol, du 1-undécanethiol, du 1-dodécanethiol et du 1-tridécanethiol.

3. Procédé de nettoyage d'une tranche selon la revendication 2, dans lequel le solvant de dilution contient, sur la base de 100 % en masse du solvant de dilution entier, de 80 à 100 % en masse d'au moins un type de produit choisi dans le groupe constitué du diamyl éther, du dihexyl éther, du décane, du dodécane, de la décaline, du 1-dodécanethiol, du 1-décanethiol et du 1-octanethiol.

4. Procédé de nettoyage d'une tranche selon l'une quelconque des revendications 1 à 3, dans lequel l'acide sulfonique est un acide choisi dans le groupe constitué d'acide sulfoniques représentés par la formule générale suivante [4]
R⁵-S(=O)₂OH [4]
où R⁵ est un groupement choisi dans le groupe constitué de groupements hydrocarbonés en C₁ à C₈ monovalents dans lesquels une partie ou tous les atomes d'hydrogène peuvent être substitués avec un atome de fluor.

5. Procédé de nettoyage d'une tranche selon l'une quelconque des revendications 1 à 3, dans lequel l'anhydride de l'acide sulfonique est au moins un produit choisi dans le groupe constitué d'anhydrides des acides sulfoniques représentés par la formule générale suivante [4]
R⁵-S(=O)₂OH [4]
où R⁵ est un groupement choisi dans le groupe constitué de groupements hydrocarbonés en C₁ à C₈ monovalents dans lesquels une partie ou tous les atomes d'hydrogène peuvent être substitués avec un atome de fluor.

6. Procédé de nettoyage d'une tranche selon l'une quelconque des revendications 1 à 3, dans lequel le sel de l'acide sulfonique est au moins un sel choisi dans le groupe constitué des sels d'ammonium et des sels d'alkylamine d'acides sulfoniques représentés par la formule générale suivante [4]
R⁵-S(=O)₂OH [4]
où R⁵ est un groupement choisi dans le groupe constitué de groupements hydrocarbonés en C₁ à C₈ monovalents dans lesquels une partie ou tous les atomes d'hydrogène peuvent être substitués avec un atome de fluor.

7. Procédé de nettoyage d'une tranche selon l'une quelconque des revendications 1 à 3, dans lequel le dérivé de l'acide sulfonique est au moins un dérivé choisi dans le groupe constitué de dérivés d'acide sulfonique représentés par la formule générale suivante [5]
R⁶-S(=O)₂O-Si(CH₃)₂(R⁷) [5]
où R⁶ est un groupement hydrocarboné en C₁ à C₈ monovalent dans lequel une partie ou tous les atomes d'hydrogène peuvent être substitués avec un atome de fluor ; et R⁷ est un groupement hydrocarboné en C₁ à C₁₈ monovalent dans lequel une partie ou tous les d'hydrogène peuvent être substitués avec un atome de fluor.

8. Procédé de nettoyage d'une tranche selon l'une quelconque des revendications 1 à 7, dans lequel l'alcoxysilane est au moins un silane choisi dans le groupe constitué d'alcoxysilanes représentés par la formule générale suivante [7]
(R¹⁰)*_{d}*Si(OR¹¹)_{*4*-*d*} [7]
où chaque R¹⁰ est de manière indépendante un groupement hydrocarboné en C₁ à C₁₈ monovalent dans lequel une partie ou tous les atomes d'hydrogène peuvent être substitués avec un atome de fluor ; chaque R¹¹ est de manière indépendante un groupement hydrocarboné en C₁ à C₁₂ monovalent ; et d est égal à 2 ou 3.

9. Procédé de nettoyage d'une tranche selon l'une quelconque des revendications 1 à 8, dans lequel l'alcoxysilane est au moins un silane choisi dans le groupe constitué des mono alcoxysilanes représentés par la formule générale suivante [8]
(R¹⁰)-Si(CH₃)₂(OR¹¹) [8]
où R¹⁰ est un groupement hydrocarboné en C₁ à C₁₈ monovalent dans lequel une partie ou tous les atomes d'hydrogène peuvent être substitués avec un atome de fluor ; et R¹¹ est un groupement hydrocarboné en C₁ à C₁₂ monovalent.

10. Procédé de nettoyage d'une tranche selon l'une quelconque des revendications 1 à 9, dans lequel une concentration de l'alcoxysilane dans le produit chimique liquide filmogène protecteur hydrofuge est de 0,5 à 35 % en masse.

11. Procédé de nettoyage d'une tranche selon l'une quelconque des revendications 1 à 10, dans lequel une concentration totale de l'acide sulfonique, de l'anhydride d'acide sulfonique, du sel de l'acide sulfonique et du dérivé de l'acide sulfonique dans le produit chimique liquide filmogène protecteur hydrofuge est de 0,0001 à 5 % en masse.

12. Procédé de nettoyage d'une tranche selon l'une quelconque des revendications 1 à 11, comprenant en outre, après la retenue du produit chimique liquide filmogène protecteur hydrofuge au moins dans la partie en retrait du motif inégal et ainsi la formation du film protecteur hydrofuge sur la surface de la partie en retrait, le retrait du produit chimique liquide filmogène protecteur hydrofuge de la partie en retrait par un séchage.

13. Procédé de nettoyage d'une tranche selon l'une quelconque des revendications 1 à 11, comprenant en outre, après la retenue du produit chimique liquide filmogène protecteur hydrofuge au moins dans la partie en retrait du motif inégal et ainsi la formation du film protecteur hydrofuge sur la surface de la partie en retrait, le remplacement du produit chimique liquide filmogène protecteur hydrofuge dans la partie en retrait avec un liquide de nettoyage, qui est différent du produit chimique liquide filmogène protecteur hydrofuge, et ensuite le retrait du liquide de nettoyage de la partie en retrait par un séchage.

14. Procédé de nettoyage d'une tranche selon la revendication 12 ou la revendication 13, comprenant en outre, après le séchage, l'exécution d'au moins un traitement choisi dans le groupe constitué d'un traitement thermique, d'un traitement d'irradiation par de la lumière, d'un traitement d'exposition à l'ozone, d'un traitement d'irradiation par plasma et d'un traitement par décharge corona, sur la surface de la tranche de sorte à ainsi enlever le film protecteur hydrofuge.

15. Procédé de nettoyage d'une tranche selon l'une quelconque des revendications 1 à 14, la préparation du produit chimique liquide filmogène protecteur hydrofuge en mélangeant un kit de produit chimique liquide filmogène protecteur hydrofuge,
le kit de produit chimique liquide filmogène protecteur hydrofuge comprenant au moins des premier et deuxième liquides,
le premier liquide incluant l'alcoxysilane représenté par la formule générale ci-dessus [1], ou incluant l'alcoxysilane représenté par la formule générale ci-dessus [1] et le solvant de dilution,
le deuxième liquide incluant l'au moins un type de produit choisi dans le groupe constitué de l'acide sulfonique représenté par la formule générale ci-dessus [2], l'anhydride de l'acide sulfonique, le sel de l'acide sulfonique et le dérivé de l'acide sulfonique représenté par la formule générale ci-dessus [3], ou incluant l'au moins un type de produit choisi dans le groupe constitué de l'acide sulfonique représenté par la formule générale ci-dessus [2], l'anhydride de l'acide sulfonique, le sel de l'acide sulfonique et le dérivé de l'acide sulfonique représenté par la formule générale ci-dessus [3] et le solvant de dilution,
au moins un parmi les premier et deuxième liquides contenant le solvant de dilution.

16. Produit chimique liquide filmogène protecteur hydrofuge pour une utilisation dans un processus de nettoyage d'un tranche au moyen d'une machine de nettoyage de tranches, la tranche ayant sur une de ses surfaces un motif inégal fin contenant au moins partiellement un élément silicium, la machine de nettoyage de tranches ayant une partie de contact liquide contenant une résine de chlorure de vinyle, le produit chimique liquide filmogène protecteur hydrofuge comprenant :
un alcoxysilane représenté par la formule générale suivante [1] ; au moins un type de produit choisi dans le groupe constitué d'un acide sulfonique représenté par la formule générale suivante [2], un anhydride de l'acide sulfonique, un sel de l'acide sulfonique et un dérivé de l'acide sulfonique représenté par la formule générale suivante [3] ; et un solvant de dilution,
(R¹)*ₐ*Si(H)*_{b}*(OR²)_{4-*a*-*b*} [1]
où chaque R¹ est de manière indépendante au moins un groupement choisi dans le groupe constitué de groupements hydrocarboné en C₁ à C₁₈ monovalents dans lesquels une partie ou tous les atomes d'hydrogène peuvent être substitués avec un atome de fluor ; chaque R² est de manière indépendante un groupement hydrocarboné en C₁ à C₁₈ monovalent dans lequel une partie ou tous les atomes d'hydrogène peuvent être substitués avec un atome de fluor; a est un nombre entier de 1 à 3 ; *b* est un nombre entier de 0 à 2 ; et une somme de a et de *b* est égale ou inférieure à 3,
R³-S(=O)₂OH [2]
où R³ est un groupement choisi dans le groupe constitué de groupements hydrocarbonés en C₁ à C₈ monovalents dans lesquels une partie ou tous les atomes d'hydrogène peuvent être substitués avec un atome de fluor, et un groupement hydroxyle,
R³-S(=O)₂O-Si(H)_{3-*c*}(R⁴)*_{c}* [3]
où R³ est un groupement hydrocarboné en C₁ à C₈ monovalent dans lequel une partie ou tous les atomes d'hydrogène peuvent être substitués avec un atome de fluor ; chaque R⁴ est de manière indépendante au moins un groupement choisi dans le groupe constitué de groupements hydrocarboné en C₁ à C₁₈ monovalents dans lesquels une partie ou tous les atomes d'hydrogène peuvent être substitués avec un atome de fluor ; et *c* est un nombre entier de 1 à 3,
**caractérisé en ce que** :
le solvant de dilution contient, sur la base de 100 % en masse du solvant de dilution entier, de 80 à 100 % en masse d'au moins un type deproduit choisi dans le groupe constitué de l'hexane, l'heptane, l'octane, le nonane, le décane, le dodécane, le tétradécane, l'hexadécane, l'octadécane, l'éicosane, le cyclohexane, le méthylcyclohexane, la décaline, le benzène, le toluène, le xylène, le diéthylbenzène, le dipropyl éther, l'éthyl butyl éther, le dibutyl éther, l'éthyl amyl éther, le diamyl éther, le méthyl cyclopentyl éther, l'éthyl hexyl éther, le dihexyl éther, le dioctyl éther, le diphényl éther, le méthyl perfluoropropyl éther, l'éthyl perfluorobutyl éther, le méthyl perfluorohexyl éther, l'éthyl perfluorohexyl éther, le 1-hexanethiol, le 2-hexanethiol, le 3-hexanethiol, le 2-méthyl-1-pentanethiol, le 3 -méthyl-1-pentanethiol, le 4-méthyl-1-pentanethiol, le 2-méthyl-2-pentanethiol, le 3-méthyl-2-pentanethiol, le 4-méthyl-2-pentanethiol, le 2-méthyl-3-pentanethiol, le 3-méthyl-3-pentanethiol, le 2,2-diméthyl-1-butanethiol, le 3,3-diméthyl-1-butanethiol, le 3,3-diméthyl-2-butanethiol, le 2-éthyl-1-butanethiol, le 1-heptanethiol, le 2-heptanethiol, le 3-heptanethiol, le 4-heptanethiol, le benzylthiol, le 1-octanethiol, le 2-octanethiol, le 3-octanethiol, le 4-octanethiol, le 2-éthyl-1-hexanethiol, le 1-nonanethiol, le 2-nonanethiol, le 3-nonanethiol, le 4-nonanethiol, le 5-nonanethiol, le 1-décanethiol, le 2-décanethiol, le 3-décanethiol, le 4-décanethiol, le 5-décanethiol, le tert-décanethiol, le 1-undécanethiol, le 2-undécanethiol, le 3-undécanethiol, le 4-undécanethiol, le 5-undécanethiol, le 6-undécanethiol, le 1-dodécanethiol, le 2-dodécanethiol, le 3-dodécanethiol, le 4-dodécanethiol, le 5-dodécanethiol, le 6-dodécanethiol, le tert-dodécanethiol, le 1-tridécanethiol, le 2-tridécanethiol, le 3-tridécanethiol, le 4-tridécanethiol, le 5-tridécanethiol, le 6-tridécanethiol et le 7-tridécanethiol, dans lequel l'hexane, l'heptane, l'octane, le nonane, le décane, le dodécane, le tétradécane, l'hexadécane, l'octadécane et l'éicosane peuvent être sous forme linéaire ou sous forme ramifiée et les éthers peuvent être sous forme linéaire ou sous forme branchée.

17. Produit chimique liquide filmogène protecteur hydrofuge selon la revendication 16, dans lequel le solvant de dilution contient, sur la base de 100 % en masse du solvant de dilution entier, de 80 à 100 % en masse d'au moins un type de produit choisi dans le groupe constitué de l'octane, du nonane, du décane, du dodécane, du cyclohexane, du méthylcyclohexane, de la décaline, de l'éthyl t-butyl éther, du méthyl cyclopentyl éther, du méthyl perfluoropropyl éther, de l'éthyl perfluorobutyl éther, du méthyl perfluorohexyl éther, de l'éthyl perfluorohexyl éther, du dibutyl éther, du diamyl éther, du dihexyl éther, du dioctyl éther, du 1-hexanethiol, du 2-méthyl-1 - pentanethiol, du 3-méthyl-1 -pentanethiol, du 4-méthyl-1-pentanethiol, du 2.2-diméthyl-1 -butanethiol, du 3,3-diméthyl-1-butanethiol, du 2-éthyl-1 - butanethiol, du 1-heptanethiol, du benzylthiol, du 1-octanethiol, du 2-éthyl-1-hexanethiol, du 1-nonanethiol, du 1-décanethiol, du 1-undécanethiol, du 1-dodécanethiol et du 1-tridécanethiol.

18. Produit chimique liquide filmogène protecteur hydrofuge selon la revendication 17, dans lequel le solvant de dilution contient, sur la base de 100 % en masse du solvant de dilution entier, de 80 à 100 % en masse d'au moins un type de produit choisi dans le groupe constitué du diamyl éther, du dihexyl éther, du décane, du dodécane, de la décaline, du 1-dodécanethiol, du 1-décanethiol et du 1-octanethiol.

19. Produit chimique liquide filmogène protecteur hydrofuge selon l'une quelconque des revendications 16 à 18, dans lequel l'acide sulfonique est au moins un acide choisi dans le groupe constitué d'acides sulfoniques représentés par la formule générale suivante [4]
R⁵-S(=O)₂OH [4]
où R⁵ est un groupement choisi dans le groupe constitué de groupements hydrocarbonés en C à C8 monovalents dans lesquels une partie ou tous les atomes d'hydrogène peuvent être substitués avec un atome de fluor.

20. Produit chimique liquide filmogène protecteur hydrofuge selon l'une quelconque des revendications 16 à 18, dans lequel l'anhydride de l'acide sulfonique est au moins un anhydride choisi dans le groupe constitué d'anhydrides d'acides sulfoniques représentés par la formule générale suivante [4]
R⁵-S(=O)₂OH [4]
où R⁵ est un groupement choisi dans le groupe constitué de groupements hydrocarbonés en C₁ à C₈ monovalents dans lesquels une partie ou tous les atomes d'hydrogène peuvent être substitués avec un atome de fluor.

21. Produit chimique liquide filmogène protecteur hydrofuge selon l'une quelconque des revendications 16 à 18, dans lequel le sel de l'acide sulfonique est au moins un sel choisi dans le groupe constitué de sels d'ammonium et de sels alkylamine d'acides sulfoniques représenté par la formule générale suivante [4]
R⁵-S(=O)₂OH [4]
où R⁵ est un groupement choisi dans le groupe constitué de groupements hydrocarbonés en C₁ à C₈ monovalents dans lesquels une partie ou tous les atomes d'hydrogène peuvent être substitués avec un atome de fluor.

22. Produit chimique liquide filmogène protecteur hydrofuge selon l'une quelconque des revendications 16 à 18, dans lequel le dérivé de l'acide sulfonique est au moins un dérivé choisi dans le groupe constitué de dérivés d'acide sulfonique représentés par la formule générale suivante [5]
R⁶-S(=O)₂O-Si(CH₃)₂(R⁷) [5]
où R⁶ est un groupement hydrocarboné en C₁ à C₈ monovalent dans lequel une partie ou tous les atomes d'hydrogène peuvent être substitués avec un atome de fluor ; et R⁷ est un groupement hydrocarboné en C₁ à C₁₈ monovalent dans lequel une partie ou tous les atomes d'hydrogène peuvent être substitués avec un atome de fluor.

23. Produit chimique liquide filmogène protecteur hydrofuge selon l'une quelconque des revendications 16 à 22, dans lequel l'alcoxysilane est au moins un alcoxysilane choisi dans le groupe constitué d'alcoxysilanes représentés par la formule générale suivante [7]
(R¹⁰)*_{d}*Si(OR¹¹)_{4-*d*} [7]
où chaque R¹⁰ est de manière indépendante un groupement hydrocarboné en C₁ à C₁₈ monovalent dans lequel une partie ou tous les atomes d'hydrogène peuvent être substitués avec un atome de fluor ; chaque R¹¹ est de manière indépendante un groupement hydrocarboné en C₁ à C₁₂ monovalent ; et *d* est égal à 2 ou à 3.

24. Produit chimique liquide filmogène protecteur hydrofuge selon l'une quelconque des revendications 16 à 23, dans lequel l'alcoxysilane est au moins un alcoxysilane choisi dans le groupe constitué de mono alcoxysilanes représentés par la formule générale suivante [8]
(R¹⁰)-Si(CH₃)₂(OR¹¹) [8]
où R¹⁰ est un groupement hydrocarboné en C₁ à C₁₈ monovalent dans lequel une partie ou tous les atomes d'hydrogène peuvent être substitués avec un atome de fluor ; et R¹¹ est un groupement hydrocarboné en C₁ à C₁₂ monovalent.

25. Produit chimique liquide filmogène protecteur hydrofuge selon l'une quelconque des revendications 16 à 24, dans lequel une concentration de l'alcoxysilane dans le produit chimique liquide filmogène protecteur hydrofuge est de 0,5 à 35 % en masse.

26. Produit chimique liquide filmogène protecteur hydrofuge selon l'une quelconque des revendications 16 à 25, dans lequel une concentration totale de l'acide sulfonique, de l'anhydride de l'acide sulfonique, du sel de l'acide sulfonique et du dérivé de l'acide sulfonique dans le produit chimique liquide filmogène protecteur hydrofuge, est de 0,0001 à 5 % en masse.

27. Kit de produit chimique liquide filmogène protecteur hydrofuge devant être mélangé pour préparer le produit chimique liquide filmogène protecteur hydrofuge selon l'une quelconque des revendications 16 à 26, comprenant au moins les premier et deuxième liquides,
le premier liquide contenant l'alcoxysilane représenté par la formule générale ci-dessus [1], ou contenant l'alcoxysilane représenté par la formule générale ci-dessus [1] et le solvant de dilution,
le deuxième liquide contenant l'au moins un type de produit choisi dans le groupe constitué de l'acide sulfonique représenté par la formule générale ci-dessus [2], l'anhydride de l'acide sulfonique, le sel de l'acide sulfonique et le dérivé de l'acide sulfonique représenté par la formule générale ci-dessus [3], ou contenant l'au moins un type de produit choisi dans le groupe constitué de l'acide sulfonique représenté par la formule générale ci-dessus [2], l'anhydride de l'acide sulfonique, le sel de l'acide sulfonique et le dérivé de l'acide sulfonique représenté par la formule générale ci-dessus [3] et le solvant de dilution,
au moins un parmi les premier et deuxième liquides contenant le solvant de dilution.
